# EUROPEAN PATENT SPECIFICATION

(11) **EP 4 498 662 B1**
(45) Date of publication and mention of the grant of the patent: **01.04.2026**
(21) Application number: 23775144.1
(22) Date of filing: 26.01.2023
(51) Int. Cl.: G06F 1/16, G06F 1/26, G06F 1/3212, G06F 1/3287, H04M 1/02, H02J 50/10, H02J 50/90, H05K 1/02, H05K 1/18

(54) **ELECTRONIC DEVICE COMPRISING WIRELESS CHARGING FUNCTION AND OPERATING METHOD THEREFOR**
ELEKTRONISCHE VORRICHTUNG MIT DRAHTLOSER LADEFUNKTION UND BETRIEBSVERFAHREN DAFÜR
DISPOSITIF ÉLECTRONIQUE À FONCTION DE CHARGE SANS FIL ET SON PROCÉDÉ DE FONCTIONNEMENT

(30) Priority: 22.03.2022 KR 20220035604; 15.07.2022 KR 20220087689
(43) Date of publication of application: 29.01.2025
(73) Proprietor: Samsung Electronics Co., Ltd., Suwon-si, Gyeonggi-do 16677 (KR)
(72) Inventor: KWAK, Myunghoon, Suwon-si, Gyeonggi-do 16677 (KR); KIM, Bohyeon, Suwon-si, Gyeonggi-do 16677 (KR); CHO, Baekeun, Suwon-si, Gyeonggi-do 16677 (KR); LEE, Junghyeob, Suwon-si, Gyeonggi-do 16677 (KR); HONG, Hyunju, Suwon-si, Gyeonggi-do 16677 (KR)
(74) Representative: Appleyard Lees IP LLP
(86) International application number: PCT/KR2023/001207
(87) International publication number: WO 2023/182641

(56) References cited:
- KR-A- 20190 042 401
- KR-A- 20190 115 888
- KR-A- 20190 124 009
- KR-A- 20190 136 690
- KR-A- 20200 102 256
- KR-A- 20210 127 484
- US-A1- 2022 019 261

## Description

### Technical Field

Various embodiments of the disclosure relate to an electronic device, e.g., an electronic device including a wireless charging function, and a method for operating the same.

### Background Art

Advancing information communication and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. These electronic devices have been downsized to be conveniently carried by users.

As mobile communication services extend up to multimedia service sectors, the display of the electronic device may be increased to allow the user satisfactory use of multimedia services as well as voice call or text messaging services.

Recently, an electronic device including a rollable display or a flexible display has been proposed to increase the convenience of use of multimedia services while providing better portability. For example, an electronic device including a rollable display or a flexible display may extend the screen display area according to sliding or folding, allowing for convenient use of a multimedia service or game and, when carried, it may be downsized. Background information is found in published patent documents US2022019261 (KANG JOOYOUNG [KR], et al) and KR20200102256 (SAMSUNG ELECTRONICS CO LTD [KR]).

The above-described information may be provided as background for the purpose of helping understanding of the disclosure. No claim or determination is made as to whether any of the foregoing is applicable as background art in relation to the disclosure.

### Detailed Description of the Invention

### Technical Problem

A rollable device (e.g., an electronic device including a rollable display or a flexible display) may include a plurality of structures (e.g., housings or plates) that slide relative to each other. Various electrical/electronic components may be disposed in at least two different structures of the rollable device, and electrical/electronic components disposed in different structures may be electrically connected through a wiring structure such as a cable or a flexible printed circuit board (FPCB). In such a rollable device, since the rollable display is deformed into a flat shape and a curved shape while moving on the plurality of structures, it may be difficult for the rollable device to be wiredly connected to an external electronic device. For example, it may be difficult to arrange various connectors while excluding interference with the rollable display in the rollable device, and thus a wireless method may be useful in supplying charging power or connecting to an external electronic device.

The wiring structure may provide an electrical connection structure inside the rollable device while providing a transmission path of such charging power or a signal transmitted/received to/from an external electronic device. Further, the wiring structure may be moved or deformed according to relative displacement of two different structures inside the rollable device. For example, when a wiring structure is implemented using a flexible printed circuit board inside two different structures, the flexible printed circuit board may have an appropriate degree of flexibility. When the conductive line or conductive wire of the flexible printed circuit board has a sufficient thickness and line width, the flexible printed circuit board may provide a stable electrical connection, but may be less flexible. When the thickness or line width of the conducting line is reduced, it is possible to secure the flexibility of the flexible printed circuit board, but it may be difficult to secure stable electrical wiring for providing power or various signals. In other words, securing flexibility in the flexible printed circuit board and securing stable electrical wiring may be exclusive to each other.

In implementing a relative movement of housings (or frames) of the rollable device, a driving device including a motor (e.g., a servo motor or a step motor) may be utilized. The driving power for the mechanical driving device may be required to be relatively large compared to the system power used for various signal processing or information input/output. Accordingly, when driving power is required, relatively large power is applied to the electrical line of the flexible printed circuit board having a limited power transmission capacity, thereby causing instability in power supply.

Various embodiments of the disclosure are to address at least the above-described problems and/or disadvantages and to provide the advantages described below, and may provide an electronic device including stable electrical wiring inside two structures movably coupled to each other and/or an operating method thereof.

Various embodiments of the disclosure may provide an electronic device having a wireless charging function and capable of stably supplying power and/or an operating method thereof.

Other aspects according to various embodiments will be suggested through in the following detailed description and would be partially apparent from the description or appreciated through the suggested embodiments.

### Technical Solution

An electronic device is provided as set out in the accompanying claims.

A method for operating an electronic device is provided, as set out in the accompanying claims.

### Advantageous Effects

By the electronic device and the operation method thereof according to various embodiments of the disclosure, it is possible to stably transmit power through a flexible printed circuit board having a limited power transmission capacity.

Further, when the electronic device is wirelessly charged, power off of the electronic device may be prevented by supplying power to the power supply circuit and the driving circuit using the battery.

Other various effects may be provided directly or indirectly in the disclosure.

### Brief Description of the Drawings

The foregoing and other aspects, configurations, and/or advantages of various embodiments of the disclosure will be more apparent from the following detailed description taken in conjunction with the accompanying drawings.
FIG. 1 is a block diagram illustrating an electronic device in a network environment according to various embodiments of the disclosure;
FIG. 2A is a view illustrating a state in which a second display area of a display is received in a housing according to various embodiments of the disclosure.
FIG. 2B is a view illustrating a state in which a second display area of a display is exposed to the outside of a housing according to various embodiments of the disclosure;
FIG. 3 is an exploded perspective view illustrating an electronic device according to various embodiments of the disclosure;
FIG. 4A is a cross-sectional view taken along line A-A' of FIG. 2A according to various embodiments of the disclosure.
FIG. 4B is a cross-sectional view taken along line B-B' of FIG. 2B according to various embodiments of the disclosure.
FIG. 5 is an exploded perspective view illustrating an electronic device according to an embodiment of the disclosure;
FIG. 6 is an exploded perspective view illustrating the electronic device of FIG. 5, as viewed in a different direction;
FIG. 7 is a perspective view illustrating a received state of a second display area in the electronic device of FIG. 5;
FIG. 8 is a perspective view illustrating the received state of the second display area in the electronic device of FIG. 5 as viewed in a different direction;
FIG. 9 is a plan view or rear view illustrating a received state of a second display area in the electronic device of FIG. 5;
FIG. 10 is a perspective view illustrating an exposed state of a second display area in the electronic device of FIG. 5;
FIG. 11 is a perspective view illustrating the exposed state of the second display area in the electronic device of FIG. 5 as viewed in a different direction;
FIG. 12 is a plan view or rear view illustrating an exposed state of a second display area in the electronic device of FIG. 5;
FIG. 13 is a block diagram illustrating a hardware configuration of an electronic device according to various embodiments of the disclosure;
FIG. 14 is a block diagram illustrating a power supply state of an electronic device according to a first embodiment of the disclosure;
FIG. 15 is a flowchart illustrating a method for operating an electronic device according to an embodiment of the disclosure;
FIG. 16 is a flowchart illustrating a method for operating an electronic device according to another embodiment of the disclosure;
FIG. 17 is a flowchart illustrating a method for operating an electronic device according to another embodiment of the disclosure;
FIG. 18 is a block diagram illustrating a power supply state of an electronic device according to a second embodiment of the disclosure;
FIG. 19 is a block diagram illustrating a power supply state of an electronic device according to a third embodiment of the disclosure;
FIG. 20 is a plan view or rear view illustrating an exposed state of a second display area in an electronic device according to another embodiment of the disclosure;
FIG. 21A is a block diagram illustrating an electronic device having a wireless charging unit on a first circuit board according to an embodiment of the disclosure;
FIG. 21B is a block diagram illustrating an electronic device having a wireless charging unit on a second circuit board according to an embodiment of the disclosure; and
FIG. 22 is a block diagram illustrating a power supply state of an electronic device according to a fourth embodiment of the disclosure.

Throughout the drawings, like reference numerals may be assigned to like parts, components, and/or structures.

### Mode for Carrying out the Invention

The following description taken in conjunction with the accompanying drawings may provide an understanding of various exemplary implementations. Descriptions of well-known functions and configurations may be omitted for clarity and brevity.

The terms and words used in the following description and claims are not limited to the bibliographical meaning, but may be used to clearly and consistently describe the various embodiments of the disclosure.

The singular forms "a," "an," and "the" are intended to include the plural forms as well, unless the context clearly indicates otherwise. Thus, as an example, "a component surface" may be interpreted as including one or more of the surfaces of a component.

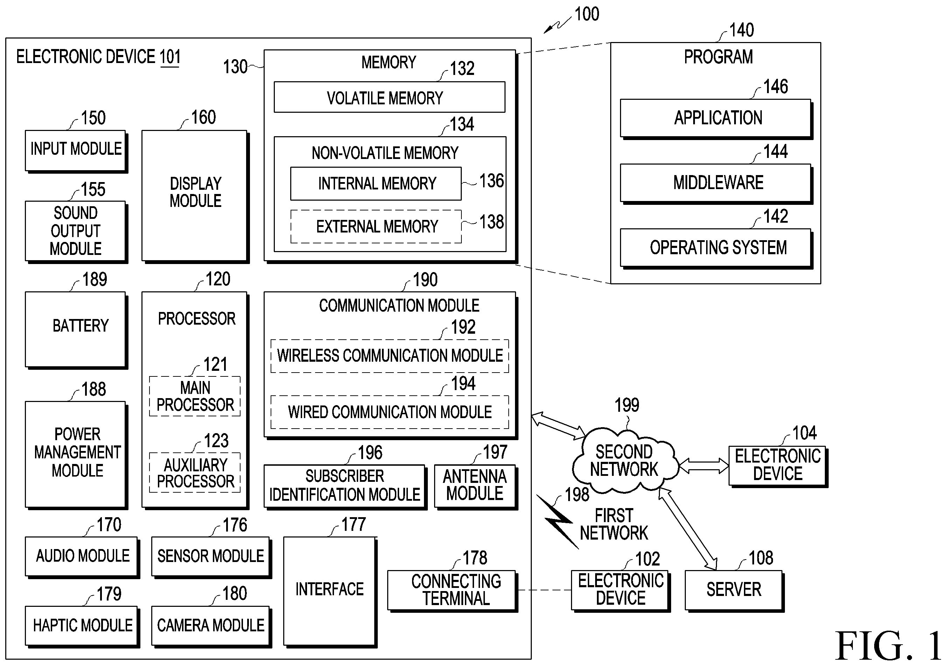

FIG. 1 is a block diagram illustrating an electronic device 101 in a network environment 100 according to various embodiments. Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via a first network 198 (e.g., a short-range communication network, such as BluetoothTM, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or loT-related technology.

The electronic device according to various embodiments may be one of various types of devices. The electronic devices may include, for example, a portable communication device (e.g., a smartphone), a computer device, a portable multimedia device, a portable medical device, a camera, a wearable device, or a home appliance. The electronic devices according to an embodiment are not limited to those described above.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semipermanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play StoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

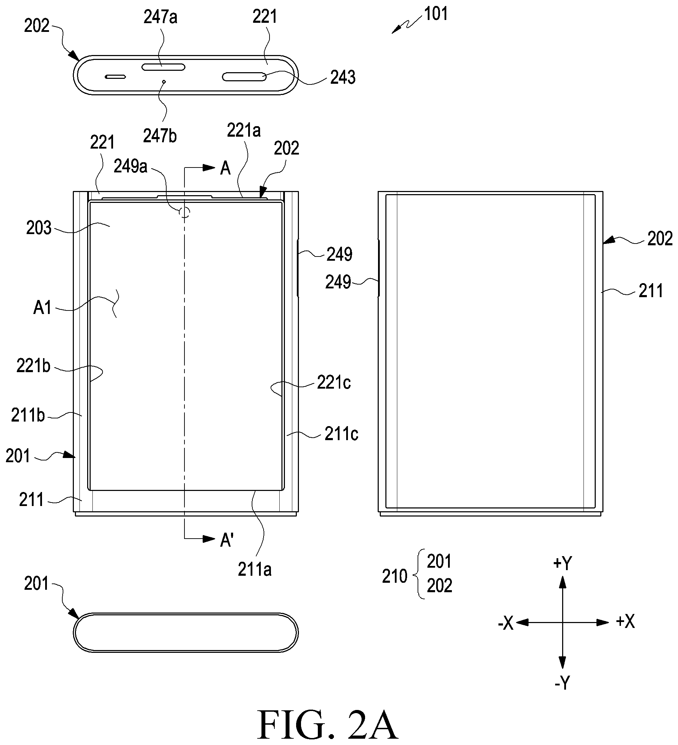

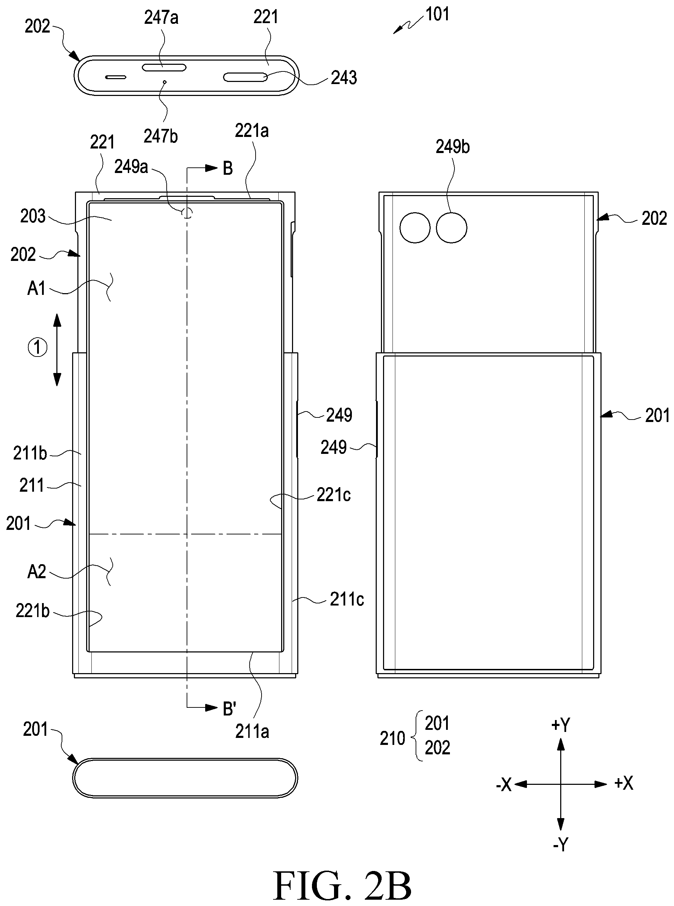

FIG. 2A is a view illustrating a state in which a second display area of a display is received in a housing according to various embodiments of the disclosure. FIG. 2B is a view illustrating a state in which a second display area of a display is exposed to the outside of a housing according to various embodiments of the disclosure.

FIGS. 2A and 2B illustrate a structure in which the display 203 (e.g., flexible display or rollable display) is extended in the length direction (e.g., +Y direction) when the electronic device 101 is viewed from the front. However, the extending direction of the display 203 is not limited to one direction (e.g., +Y direction). For example, the extending direction of the display 203 may be changed in design to be extendable in the upper direction (+Y direction), right direction (e.g., +X direction), left direction (e.g., -X direction), and/or lower direction (e.g., -Y direction).

The state shown in FIG. 2A may be referred to as a closed state of the electronic device 101 or housing 210 and a slide-in state of the display 203.

The state shown in FIG. 2B may be referred to as an opened state of the electronic device 101 or housing 210 and a slide-out state of the display 203.

Referring to FIGS. 2A and 2B, the electronic device 101 may include a housing 210. The housing 210 may include a first housing **202** and a second housing 202 disposed to be movable relative to the first housing 201. According to an embodiment, the electronic device 101 may be interpreted as having a structure in which the first housing 201 is disposed to be slidable with respect to the second housing 202. According to an embodiment, the second housing 202 may be disposed to perform reciprocating motion by a predetermined distance in a predetermined direction with respect to the first housing 201, for example, a direction indicated by an arrow ①.

According to various embodiments, the second housing 202 may be referred to as a slide portion or a slide housing, and may be movable relative to the first housing 201. According to an embodiment, the second housing 202 may receive various electrical/electronic components, such as a circuit board or a battery.

According to an embodiment, the first housing 202 may have, disposed therein, a motor, a speaker, a sim socket, and/or a sub circuit board electrically connected with a main circuit board. The second housing 201 may receive a main circuit board on which electric components, such as an application processor (AP) and a communication processor (CP) are mounted.

According to various embodiments, the first housing 201 may include a first cover member 211 (e.g., a main case). The first cover member 211 may include a 1-1th sidewall 211a, a 1-2th sidewall 211b extending from the 1-1th sidewall 211a, and a 1-3th sidewall 211c extending from the 1-1th sidewall 211a and substantially parallel to the 1-2th sidewall 211b. According to an embodiment, the 1-2th sidewall 211b and the 1-3th sidewall 211c may be formed substantially perpendicular to the 1-1th sidewall 211a.

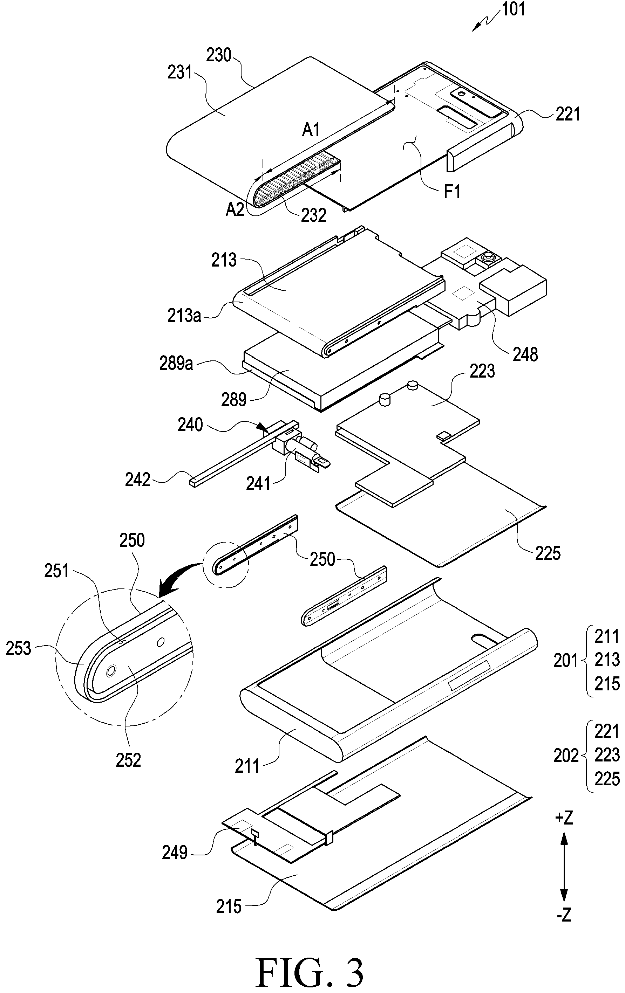

According to various embodiments, the 1-1th sidewall 211a, 1-2th sidewall 211b, and 1-3th sidewall 211c of the first cover member 211 may be formed to have a side opening (e.g., in the front surface) to receive at least a portion of the second housing 202. For example, at least a portion of the second housing 202 may be surrounded by the first housing 201 and be slid in the direction parallel to the first surface (e.g., the first surface F1 of FIG. 3), e.g., arrow ① direction, while being guided by the first housing 201. According to an embodiment, the 1-1th sidewall 211a, the 1-2th sidewall 211b, and/or the 1-3th sidewall 211c of the first cover member 211 may be integrally formed. According to an embodiment, the 1-1th sidewall 211a, the 1-2th sidewall 211b, and/or the 1-3th sidewall 211c of the first cover member 211 may be formed as separate structures and be combined or assembled.

According to various embodiments, the first cover member 211 may be formed to surround at least a portion of the display 203. For example, at least a portion of the display 203 may be formed to be surrounded by the 1-1th sidewall 211a, the 1-2th sidewall 211b, and/or the 1-3th sidewall 211c of the first cover member 211.

According to various embodiments, the second housing 202 may include a second cover member 221 (e.g., a slide plate). The second cover member 221 may have a plate shape and include a first surface (e.g., the first surface F1 of FIG. 3) supporting internal components. For example, the second cover member 221 may support at least a portion of the display 203 (e.g., the first display area A1). According to an embodiment, the second cover member 221 may be referred to as a front cover.

According to an embodiment, the second cover member 221 may include a 2-1th sidewall 221a, a 2-2th sidewall 221b extending from the 2-1th sidewall 221a, and a 2-3th sidewall 221c extending from the 2-1th sidewall 221a and substantially parallel to the 2-2th sidewall 221b. According to an embodiment, the 2-2th sidewall 221b and the 2-3th sidewall 221c may be formed substantially perpendicular to the 2-1th sidewall 221a.

According to various embodiments, as the second housing 202 moves in a first direction (e.g., direction ①) parallel to the 1-2th sidewall 211b or the 1-2th sidewall 211c, the housing 210 may form an opened state and a closed state. In the closed state, the second housing 202 may be positioned at a first distance from the 1-1th sidewall 211a and, in the opened state, the second housing 202 may be moved to be positioned at a second distance larger than the first distance from the 1-1th sidewall 211a. In some embodiments, in the closed state, the first housing 201 may surround a portion of the 2-1th side wall 221a.

According to various embodiments, the electronic device 101 may include a display 203, a key input device 245, a connector hole 243, audio modules 247a and 247b, or camera modules 249a and 249b. According to an embodiment, the electronic device 101 may further include an indicator (e.g., a light emitting diode (LED) device) or various sensor modules.

According to various embodiments, the display 203 may include a first display area A1 and a second display area A2 configured to be exposed to the outside of the electronic device 101 based on the slide of the second housing 202. According to an embodiment, the first display area A1 may be disposed on the second housing 202. For example, the first display area A1 may be disposed on the second cover member 221 of the second housing 202. According to an embodiment, the second display area A2 may extend from the first display area A1, and as the second housing 202 slides relative to the first housing 201, the second display area A2 may be received in the first housing 201 (e.g., the slide-in state) or be visually exposed to the outside of the electronic device 101 (e.g., the slide-out state).

According to various embodiments, the second display area A2 may be moved while being substantially guided by one area (e.g., the curved surface 213a of FIG. 3) of the first housing 201 and be received in the space positioned in the first housing 201 or exposed to the outside of the electronic device 101. According to an embodiment, the second display area A2 may move based on a slide of the second housing 202 in the first direction (e.g., the direction indicated by the arrow ①). For example, while the second housing 202 slides, a portion of the second display area A2 may be deformed into a curved shape in a position corresponding to the curved surface 213a of the first housing 201.

According to various embodiments, when viewed from above the second cover member 221 (e.g., front cover), if the electronic device 210 changes from the closed state to opened state (e.g., if the second housing 202 slides to extend from the first housing 201), the second display area A2 may be gradually exposed to the outside of the first housing 201 and, together with the first display area A1, form a substantially flat surface. According to an embodiment, the display 203 may be coupled with or disposed adjacent to a touch detection circuit, a pressure sensor capable of measuring the strength (pressure) of touches, and/or a digitizer for detecting a magnetic field-type stylus pen. According to an embodiment, irrespective of the closed state or opened state of the housing 210, the exposed portion of the second display area A2 may be positioned on a portion (e.g., the curved surface 213a of FIG. 3) of the first housing, and a portion of the second display area A2 may remain in the curved shape in the position corresponding to the curved surface 213a.

According to various embodiments, the key input device 245 may be positioned in one area of the first housing 201. Depending on the appearance and the state of use, the electronic device 101 may be designed to omit the illustrated key input device 245 or to include additional key input device(s). According to an embodiment, the electronic device 101 may include a key input device (not shown), e.g., a home key button or a touchpad disposed around the home key button. According to an embodiment, at least a portion of the key input device 245 may be disposed on the 1-1th sidewall 211a, the 1-2th sidewall 211b, or the 1-3th sidewall 211c of the first housing 201.

According to various embodiments, the connector hole 243 may be omitted or may receive a connector (e.g., a universal serial bus (USB) connector) for transmitting and receiving power and/or data with an external electronic device. According to an embodiment (not shown), the electronic device 101 may include a plurality of connector holes 243, and some of the plurality of connector holes 243 may function as connector holes for transmitting/receiving audio signals with an external electronic device. In the illustrated embodiment, the connector hole 243 is disposed in the second housing 202, but is not limited thereto. For example, the connector hole 243 or a connector hole not shown may be disposed in the first housing 201.

According to various embodiments, the audio modules 247a and 247b may include at least one speaker hole 247a or at least one microphone hole 247b. One of the speaker holes 247a may be provided as a receiver hole for voice calls, and the other may be provided as an external speaker hole. The electronic device 101 may include a microphone for obtaining sound. The microphone may obtain external sound of the electronic device 101 through the microphone hole 247b. According to an embodiment, the electronic device 101 may include a plurality of microphones to detect the direction of sound. According to an embodiment, the electronic device 101 may include an audio module in which the speaker hole 247a and the microphone hole 247b are implemented as one hole or may include a speaker without the speaker hole 247a (e.g., a piezo speaker).

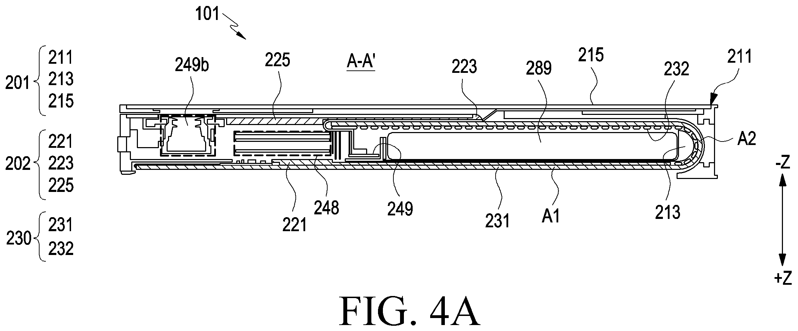

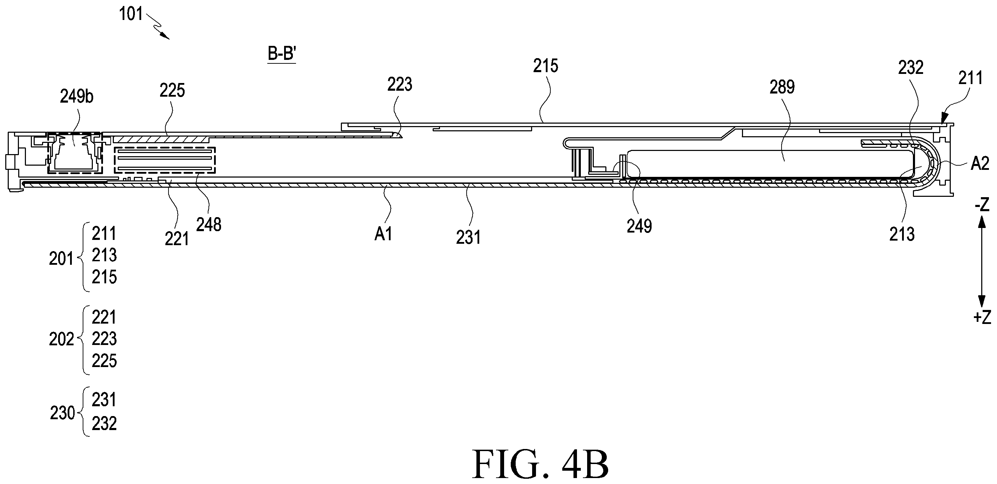

According to various embodiments, the camera modules 249a and 249b may include a first camera module 249a (e.g., a front camera) and a second camera module 249b (e.g., a rear camera) (e.g., the second camera module 249b of FIGS. 4A and 4B). According to an embodiment, the electronic device 101 may include at least one of a wide-angle camera, a telephoto camera, or a close-up camera. According to an embodiment, the electronic device 200 may measure the distance to the subject by including an infrared projector and/or an infrared receiver. The camera modules 249a and 249b may include one or more lenses, an image sensor, and/or an image signal processor. The first camera module 249a may be disposed to face in the same direction as the display 203. For example, the first camera module 249a may be disposed in an area around the first display area A1 or overlapping the display 203. When disposed in the area overlapping the display 203, the first camera module 249a may capture the subject through the display 203. According to an embodiment, the first camera module 249a may include an under display camera (UDC) that has a screen display area (e.g., the first display area A1) that may not be visually exposed but hidden. According to an embodiment, the second camera module 249b may capture the subject in a direction opposite to the first display area A1. According to an embodiment, the first camera module 249a and/or the second camera module 249b may be disposed on the second housing 202.

According to various embodiments, an indicator (not shown) of the electronic device 101 may be disposed on the first housing 201 or the second housing 202, and the indicator may include a light emitting diode to provide state information about the electronic device 101 as a visual signal. The sensor module (not shown) of the electronic device 101 may produce an electrical signal or data value corresponding to the internal operation state or external environment state of the electronic device. The sensor module may include, for example, a proximity sensor, a fingerprint sensor, or a biometric sensor (e.g., an iris/face recognition sensor or a heartrate monitor (HRM) sensor). According to another embodiment, the sensor module may further include, e.g., at least one of a gesture sensor, a gyro sensor, an atmospheric pressure sensor, a magnetic sensor, an acceleration sensor, a grip sensor, a color sensor, an infrared (IR) sensor, a temperature sensor, a humidity sensor, or an illuminance sensor.

FIG. 3 is an exploded perspective view illustrating an electronic device according to various embodiments of the disclosure;

FIG. 4A is a cross-sectional view taken along line A-A' of FIG. 2A according to various embodiments of the disclosure.

FIG. 4B is a cross-sectional view taken along line B-B' of FIG. 2B according to various embodiments of the disclosure.

Referring to FIGS. 3, 4A, and/or 4B, an electronic device 101 may include a first housing 201, a second housing 202, a display assembly 230, and a driving structure 240. The configuration of the first housing 201, the second housing 202, and the display assembly 230 of FIGS. 3, 4A, and/or 4B may be identical in whole or part to the configuration of the first housing 201, the second housing 202, and the display 203 of FIGS. 2A and/or 2B.

According to various embodiments, the first housing 201 may include a first cover member 211 (e.g., the first cover member 211 of FIGS. 2A and 2B), a frame 213, and a first rear plate 215.

According to various embodiments, the first cover member 211 may receive at least a portion of the frame 213 and receive a component (e.g., battery 289) positioned in the frame 213. According to an embodiment, the first cover member 211 may be formed to surround at least a portion of the second housing 202. According to an embodiment, the second circuit board 249 receiving the electronic component (e.g., the processor 120 and/or the memory 130 of FIG. 1) may be connected to the first cover member 211.

According to various embodiments, the frame 213 may be connected to the first cover member 211. For example, the frame 213 may be connected to the first cover member 211. The second housing 202 is movable relative to the first cover member 211 and/or the frame 213. According to an embodiment, the frame 213 may receive the battery 289. According to an embodiment, the frame 213 may include a curved portion 213a facing the display assembly 230.

According to various embodiments, the first rear plate 215 may substantially form at least a portion of the exterior of the first housing 201 or the electronic device 101. For example, the first rear plate 215 may be coupled to the outer surface of the first cover member 221. According to an embodiment, the first rear plate 215 may provide a decorative effect on the exterior of the electronic device 101. The first rear plate 215 may be formed of at least one of metal, glass, synthetic resin, or ceramic.

According to various embodiments, the second housing 202 may include a second cover member 221 (e.g., the second cover member 221 of FIGS. 2A and 2B), a rear cover 223, and a second rear plate 225.

According to an embodiment, the second cover member 221 may be connected to the first housing 201 through the guide rail 250 and, while being guided by the guide rail 250, reciprocate linearly in one direction (e.g., the direction of arrow ① in FIG. 2B).

According to various embodiments, the second cover member 221 may support at least a portion of the display 203. For example, the second cover member 221 may include a first surface F1. The first display area A1 of the display 203 may be substantially positioned on the first surface F1 to maintain a flat panel shape. According to an embodiment, the second cover member 221 may be formed of a metal material and/or a non-metal (e.g., polymer) material. According to an embodiment, the first circuit board 248 receiving the electronic component (e.g., the processor 120 and/or the memory 130 of FIG. 1) may be connected to the second cover member 221.

According to various embodiments, the rear cover 223 may protect a component (e.g., the first circuit board 248) positioned on the second cover member 221. For example, the rear cover 223 may be connected to the second cover member 221 and may be formed to surround at least a portion of the first circuit board 248. According to an embodiment, the rear cover 223 may include an antenna pattern for communicating with an external electronic device. For example, the rear cover 223 may include a laser direct structuring (LDS) antenna.

According to various embodiments, the second rear plate 225 may substantially form at least a portion of the exterior of the second housing 202 or the electronic device 101. For example, the second rear plate 225 may be coupled to the outer surface of the second cover member 221. According to an embodiment, the second rear plate 225 may provide a decorative effect on the exterior of the electronic device 101. The second rear plate 215 may be formed of at least one of metal, glass, synthetic resin, or ceramic.

According to various embodiments, the display assembly 230 may include a display 231 (e.g., the display 203 of FIGS. 2A and/or 2B) and a multi-bar structure 232 supporting the display 203. According to an embodiment, the display 231 may be referred to as a flexible display, a foldable display, and/or a rollable display.

According to various embodiments, the multi-bar structure 232 may be connected to or attached to at least a portion (e.g., the second display area A2) of the display 231. According to an embodiment, as the second housing 202 slides, the multi-bar structure 232 may move with respect to the first housing 201. In the closed state of the electronic device 101 (e.g., FIG. 2A), the multi-bar structure 232 may be mostly received in the first housing 201 and may be positioned between the first cover member 211 and the second cover member 221. According to an embodiment, at least a portion of the multi-bar structure 232 may move corresponding to the curved surface 213a positioned at the edge of the frame 213. According to an embodiment, the multi-bar structure 232 may be referred to as a display supporting member or supporting structure and may be in the form of one elastic plate.

According to various embodiments, the driving structure 240 may move the second housing 202 relative to the first housing 201. For example, the drive structure 240 may include a motor 241 configured to generate a driving force for sliding the housing 201 and 202. The driving structure 240 may include a gear (e.g., a pinion) connected to the motor 241 and a rack 242 configured to mesh with the gear.

According to various embodiments, the housing in which the rack 242 is positioned and the housing in which the motor 241 is positioned may be different. According to an embodiment, the motor 241 may be connected to the second housing 202. The rack 242 may be connected to the first housing 201. According to another embodiment, the motor 241 may be connected to the first housing 201. The rack 242 may be connected to the second housing 202.

According to various embodiments, the first housing 201 may receive the first circuit board 248 (e.g., a main board). According to an embodiment, the processor, memory, and/or interface may be mounted on the first circuit board 248. The processor may include one or more of, e.g., a central processing unit, an application processor, a graphic processing device, an image signal processing, a sensor hub processor, or a communication processor. According to various embodiments, the first circuit board 248 may include a flexible printed circuit board type radio frequency cable (FRC). The first circuit board 248 may be disposed on at least a portion of the second cover member 221 and may be electrically connected to the antenna module and the communication module.

According to an embodiment, the memory may include, e.g., a volatile or non-volatile memory.

According to an embodiment, the interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

According to various embodiments, the electronic device 101 may include a second circuit board 249 (e.g., a sub circuit board) spaced apart from the first circuit board 248 (e.g., a main circuit board) in the first housing 201. The second circuit board 249 may be electrically connected to the first circuit board 248 through a connection flexible board. The second circuit board 249 may be electrically connected with electric components disposed in an end area of the electronic device 101, such as the battery 289 or a speaker and/or a sim socket, and may transfer signals and power. According to an embodiment, the second circuit board 249 may receive a wireless charging antenna (e.g., coil). For example, the battery 289 may receive power from an external electronic device through the wireless charging antenna. As another example, the battery 289 may transfer power to the external electronic device by the wireless charging antenna.

According to various embodiments, the battery 289 may be a device for supplying power to at least one component of the electronic device 101. The battery 189 may include a primary cell which is not rechargeable, a secondary cell which is rechargeable, or a fuel cell. The battery 289 may be integrally or detachably disposed inside the electronic device 101. According to an embodiment, the battery 289 may be formed of a single embedded battery or may include a plurality of removable batteries. According to an embodiment, the battery 289 may be positioned in a frame 213, and the battery 289 may be slid along with the frame 213.

According to various embodiments, the guide rail 250 may guide the movement of the multi-bar structure 232. For example, the multi-bar structure 232 may slide along the slit 251 formed in the guide rail 250. According to an embodiment, the guide rail 250 may be connected to the first housing 201. For example, the guide rail 250 may be connected to the first cover member 211 and/or the frame 213. According to an embodiment, the slit 251 may be referred to as a groove or recess formed in the inner surface of the guide rail 250.

According to various embodiments, the guide rail 250 may provide pressure to the multi-bar structure 233 based on the driving of the motor 241.

According to an embodiment, when the electronic device 101 changes from the closed state to opened state, the inner portion 252 of the guide rail 250 may provide pressure to the multi-bar structure 232. The multi-bar structure 232 receiving the pressure may be moved along the slit 251 of the guide rail 250, and the second housing 202 may be changed from the slide-in state to slide-out state with respect to the first housing 201. At least a portion of the display assembly 230 accommodated between the first cover member 211 and the frame 213 may be extended to the front surface.

According to an embodiment, when the electronic device 101 changes from the opened state to closed state, an outer portion 253 of the guide rail 250 may provide pressure to the bent multi-bar structure 232. The multi-bar structure 232 receiving the pressure may be moved along the slit 251 of the guide rail 250, and the second housing 202 may be changed from the slide-out state to slide-in state with respect to the first housing 201. At least a portion of the display assembly 230 may be accommodated between the first cover member 211 and the frame 213.

Referring to FIG. 4A, in the closed state of the electronic device 101, at least a portion of the second housing 202 may be disposed to be received in the first housing 201. As the second housing 202 is disposed to be received in the first housing 201, the overall volume of the electronic device 101 may be reduced. According to an embodiment, when the second housing 202 is received in the first housing 201, the size of the visually exposed display 231 may be minimized. For example, if the second housing 202 is completely received in the first housing 201, the first display area A1 of the display 231 may be visually exposed, and the second display area A2 may not be visually exposed. At least a portion of the second display area A2 may be disposed between the battery 289 and the rear plate 215 and 225.

Referring to FIG. 4B, in the opened state of the electronic device 101, at least a portion of the second housing 202 may protrude from the first housing 201. As the second housing 202 is disposed to protrude from the first housing 201, the overall volume of the electronic device 101 may be increased. According to an embodiment, if the second housing 202 protrudes from the first housing 201, at least a portion of the second display area A2 of the display 231, together with the first display area A1, may be visually exposed to the outside of the electronic device 101.

Various embodiments of the electronic device 101 described in the disclosure are described below.

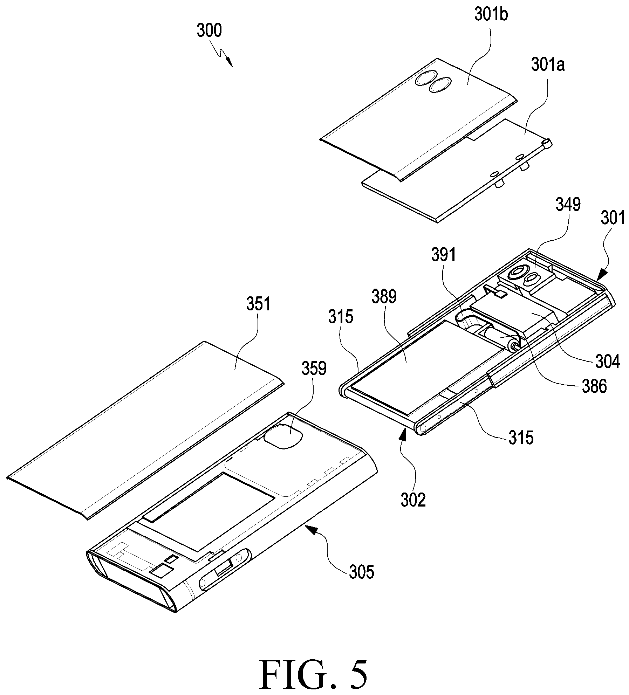

The electronic devices 300a and 300b of FIGS. 5 to 12 and/or 20 to be described below may have some differences in the arrangement of the circuit board(s) 304 and 390 or in the detailed configuration of the flexible printed circuit board (FPCB) 391 providing the connection wiring, but may be substantially identical or similar to the above-described electronic device (e.g., the electronic device 101 of FIGS. 1 to 4). Therefore, in describing the electronic devices 300a and 300b, the electronic device of the preceding embodiment may be partially referred to. In some embodiments, the configuration of the electronic device of the preceding embodiment and the configuration of the electronic device 300a or 300b of FIGS. 5 to 12 and/or 20 may be selectively combined to implement additional embodiments, and such additional embodiments may be implemented in various ways within the scope of the configuration described in the claims.

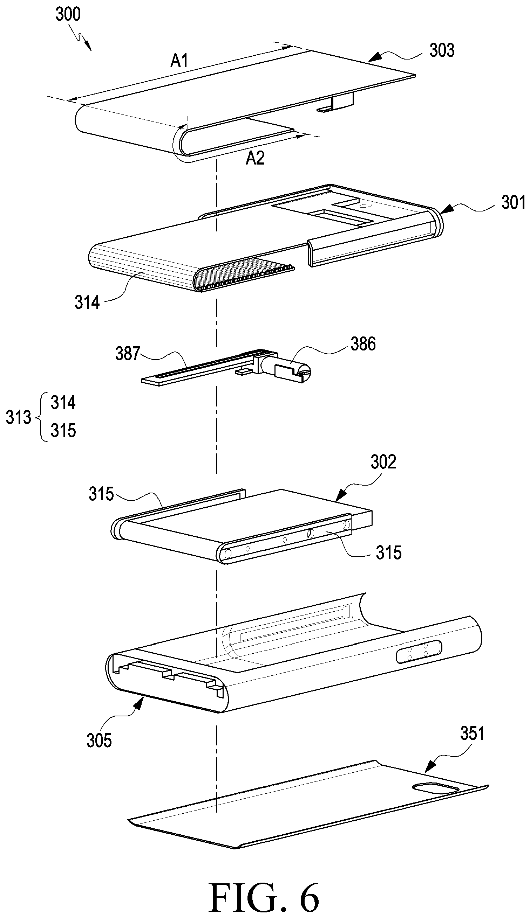

FIG. 5 is an exploded perspective view illustrating an electronic device according to an embodiment of the disclosure. FIG. 6 is an exploded perspective view illustrating the electronic device of FIG. 5, as viewed in a different direction.

Referring to FIGS. 5 and 6, an electronic device 300a may include a first housing 301, a second housing 302, a display 303 (e.g., a flexible display as the display 203 of FIG. 4), and/or a book cover 305. The first housing 301 and the second housing 302 may be substantially received in the book cover 305, and the first housing 301 may protrude to the upper end of the book cover 305 by sliding with respect to the second housing 302. For example, as the second housing 302 is fixed inside the book cover 305 and the first housing 301 and the second housing 302 move relative to each other, the first housing 301 may be extracted to the upper end of the book cover 305. In an embodiment, the first housing 301 may be fixed inside the book cover 305, and in this case, the second housing 302 may protrude to the lower end of the book cover 305 by sliding. In the illustrated embodiment, the second housing 302 may be fixed inside the book cover 305, and the first housing 301 may selectively protrude from the upper end of the book cover 305. As described through the electronic device 101 of FIGS. 2 to 4, the book cover 305 may be omitted according to an embodiment, and the structures of the first housing 301 and the second housing 302 may be appropriately changed in the structure in which the book cover 305 is omitted.

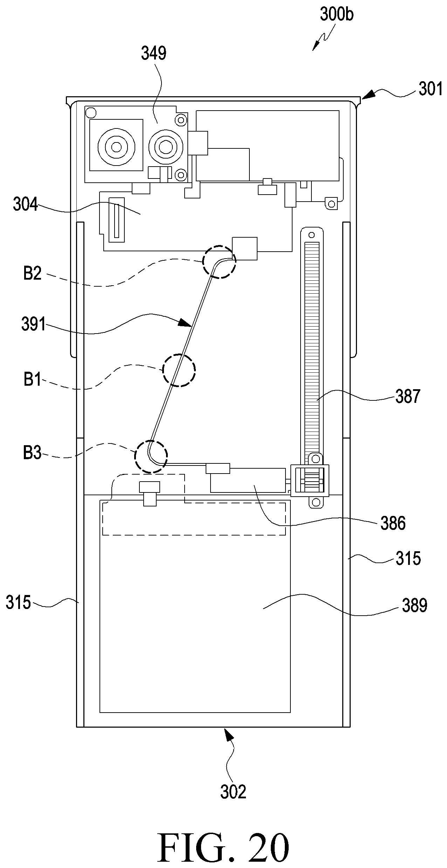

According to various embodiments, the first housing 301 may be similar to, e.g., the first housing 201 of FIG. 4, and may slide relative to the second housing 302 in a state of surrounding at least a portion of the second housing 302 or in a state of being guided by an inner wall of the book cover 305. In the state of being received in the book cover 305, the first housing 301 may at least partially overlap the second housing 302. The first housing 301 may receive, e.g., the first circuit board 304 and at least one camera module 349 (e.g., the camera modules 249a and 249b of FIG. 2 or FIG. 3). The first circuit board 304 may be provided as a main board and may include a processor, memory, a power supply circuit, and/or an interface. When the electronic device 300a includes a driving device (e.g., the driving motor 386), the first housing 301 may receive the driving motor 386. However, various embodiments of the disclosure are not limited thereto, and the driving motor 386 may be received in the second housing 302 (e.g., see FIG. 20).

According to various embodiments, the first circuit board 304 may be, e.g., a structure in which a plurality of rigid circuit boards are stacked, and according to an embodiment, the first housing 301 may include a plurality of first circuit boards 304 disposed in different areas or spaces. The camera module 349 may include a plurality of lens assemblies or a plurality of image sensors, and may photograph a subject in the front direction and/or rear direction of the electronic device 300a. In a structure in which the camera module 349 is disposed to photograph a subject in the rear direction, the book cover 305 and/or a back cover 351 (e.g., the third plate 223 of FIG. 4) to be described below may include an opening area 359 (e.g., an optically transparent area). For example, even if the first housing 301 is received in the book cover 305, the camera module 349 may be aligned with the opening area 359 to photograph a subject in the rear direction.

According to various embodiments, the first housing 301 may include a supporting member 301a and/or a slide cover 301b (e.g., the slide cover 212 of FIG. 4) coupled to the rear surface thereof. For example, the supporting member 301a and/or the slide cover 301b may be disposed in a state in which the first circuit board 304 or the camera module 349 is disposed in the first housing 301, thereby protecting electrical/electronic components in the first housing 301. In an embodiment, the slide cover 301b may form at least a portion of the exterior of the first housing 301 and/or the electronic device 300a.

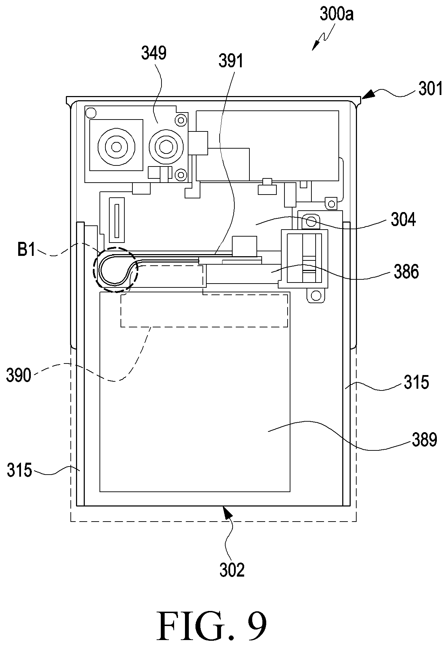

According to various embodiments, the second housing 302 may be similar to the second housing 202 of FIG. 4. However, in the electronic device 300a of the present embodiment, the structure in which the first housing 301 is coupled to at least partially surround the second housing 302 may be different from the structure of the electronic device 101 of FIG. 4. In an embodiment, the second housing 302 may receive electrical/electronic components such as the battery 389 and/or the second circuit board (e.g., the sub circuit board 290 of FIG. 4 or the second circuit board 390 of FIG. 9), and guide rails 315 (e.g., the guide rail 215 of FIG. 4) may be disposed at opposite side ends, respectively, of the second housing 302. The battery 389 and the second circuit board 390 may be electrically connected inside the second housing 302. Similar to the preceding embodiment, as the first housing 301 moves, a partial area (e.g., the second display area A2) of the display 303 may move to the inner space of the book cover 305 and/or to the outside of the book cover 305. When a partial area (e.g., the second display area A2) of the display 303 moves, the guide rail 315 may guide the movement or deformation of the second display area A2. For example, the guide rail 315 may be a part of the supporting structure 313 that supports or guides the second display area A2.

According to various embodiments, the multi-bar structure 314 may be provided as another part of the supporting structure 313. Similar to the preceding embodiment, the multi-bar structure 314 is a structure in which a plurality of bars are arranged along the sliding direction of the first housing 301, and may be deformed into a flat plate shape or a curved shape. In an embodiment, when the first housing 301 is coupled to the second housing 302, the multi-bar structure 314 may be disposed to surround at least a portion of the second housing 302 while being coupled to the guide rail 315. Since one end of the multi-bar structure 314 is substantially fixed to the first housing 301 in the moving direction (e.g., the up-down direction) of the first housing 301, the multi-bar structure 314, together with the first housing 301, may move with respect to the second housing 302.

According to various embodiments, when the multi-bar structure 314 moves with respect to the second housing 302, the guide rail 315 (e.g., the rail 2151 of FIG. 4) may guide the movement of the multi-bar structure 314 and may be deformed into a curved shape. For example, when the multi-bar structure 314 moves on the second housing 302, the multi-bar structure 314 may move to the front surface or the rear surface of the second housing 302 through a curved section (e.g., a portion of the rail 2151 of FIG. 4) of the guide rail 315. Here, the term "front surface of the second housing 302" may substantially refer to the outer space of the book cover 305, and the term "rear surface of the second housing 302" may refer to the distance between the rear surface of the second housing 302 and the book cover 305.

According to various embodiments, the display 303 may be a rollable display that may be at least partially deformed into a flat plate shape and a curved shape. In an embodiment, the display 303 may include a first display area A1 disposed on the front surface of the first housing 301 and a second display area A2 disposed on the supporting structure 313 (e.g., the multi-bar structure 314). Since the first display area A1 is substantially fixed on the first housing 301, the first display area A1, together with the first housing 301, may move with respect to the second housing 302 and/or the book cover 305. The second display area A2 is an area extending from the first display area A1, and may be moved or deformed to correspond to the movement or deformation of the multi-bar structure 314. For example, in a state in which the first housing 301 is received in the book cover 301, the second display area A1, together with the multi-bar structure 314, may be substantially received inside the electronic device 300a (e.g., the gap between the rear surface of the second housing 302 and the book cover 305), and may gradually move to the front surface of the second housing 302 through the curved section of the guide rail 315 as the first housing 301 gradually protrudes to the upper end of the book cover 305.

In an embodiment, the electronic device 300a may provide a driving force for sliding the first housing 301 using a motor driver or a driving device, e.g., the driving motor 386 (e.g., the driving motor 286 of FIG. 4) and the rack gear 387 (e.g., the rack gear 287 of FIG. 4). In an embodiment, the driving motor 386 may be disposed in the first housing 301, and the rack gear 387 may be disposed in the second housing 302 or the book cover 305. Although not shown, the driving motor 386 may rotate the pinion gear engaged with the rack gear, and the pinion gear may be rotated according to the operation of the driving motor 386 while moving on the rack gear 387. For example, the driving device may convert the rotational force of the driving motor 386 using the rack gear 387 and the pinion gear to slide the first housing 301. As is described below, the driving motor 386 may be disposed in the second housing 302, and in this case, the rack gear 387 may be disposed in the first housing 301 (e.g., see FIG. 20).

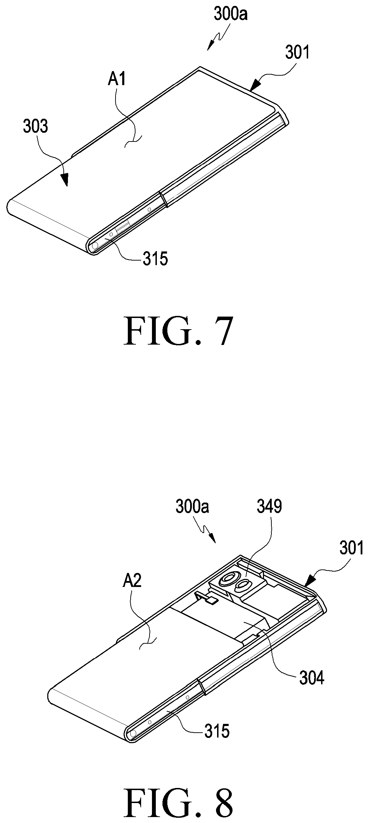

According to various embodiments, the electronic device 300a may include the flexible printed circuit board 391, thereby electrically connecting the first circuit board 304 and the second circuit board 390, and/or electrically connecting the battery 389 with the first circuit board 304. In a structure in which the battery 389 is disposed in the second housing 302 and the driving motor 386 is disposed in the first housing 301, driving power may be transferred from the battery 389 to the driving motor 386 through the flexible printed circuit board 391. The arrangement structure of the flexible printed circuit board 391 is further described with reference to FIGS. 7 to 12. It should be noted that in FIGS. 7 to 12, the arrangement of the flexible printed circuit board 391 or the movement of the display 303 is illustrated or described, with a partial structure (e.g., the book cover 305) of the above-described electronic device 300a omitted.

According to various embodiments, the flexible printed circuit board 391 may transfer an electrical signal and/or a control signal between the first circuit board 304 and the second circuit board 390.

FIG. 7 is a perspective view illustrating a received state of a second display area in the electronic device of FIG. 5. FIG. 8 is a perspective view illustrating the received state of the second display area in the electronic device of FIG. 5 as viewed in a different direction. FIG. 9 is a plan view or rear view illustrating a received state of a second display area in the electronic device of FIG. 5.

Referring further to FIGS. 7 to 9, in a state in which the first housing 301 is received in the book cover 305, the second display area A2 may be positioned substantially inside the electronic device 300a or on the rear surface of the second housing 302. The first display area A1 may be substantially exposed to the outside of the electronic device 300a regardless of whether the first housing 301 moves. The flexible printed circuit board 391 has one end connected to the first circuit board 304 and the other end connected to the second circuit board 390, and when the first housing 301 is received in the book cover 305, the flexible printed circuit board 391 may have at least a partially folded shape or a U shape. According to an embodiment, the flexible printed circuit board 391 may include conductive lines for transferring an electrical signal or power, and the first bent portion B1 in the folded state may maintain a designated radius of curvature. For example, the first bent portion B1 may maintain a radius of curvature of an appropriate size, thereby suppressing or alleviating tension or stress applied to the conducting line(s) of the flexible printed circuit board 391.

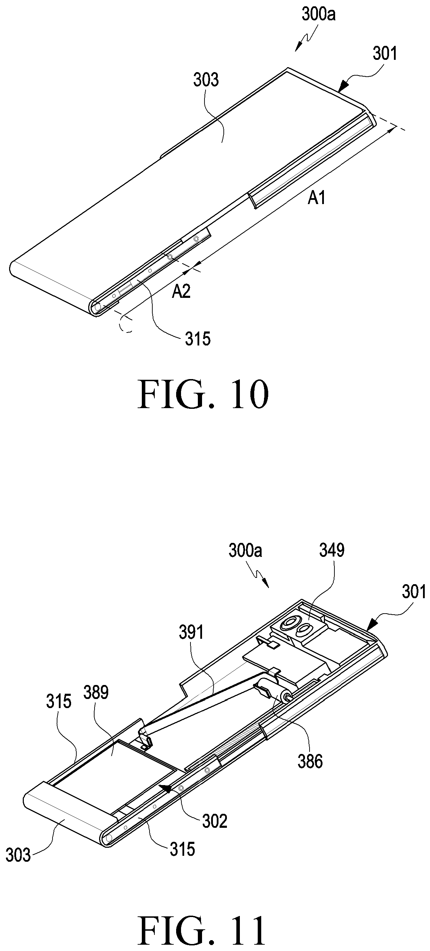

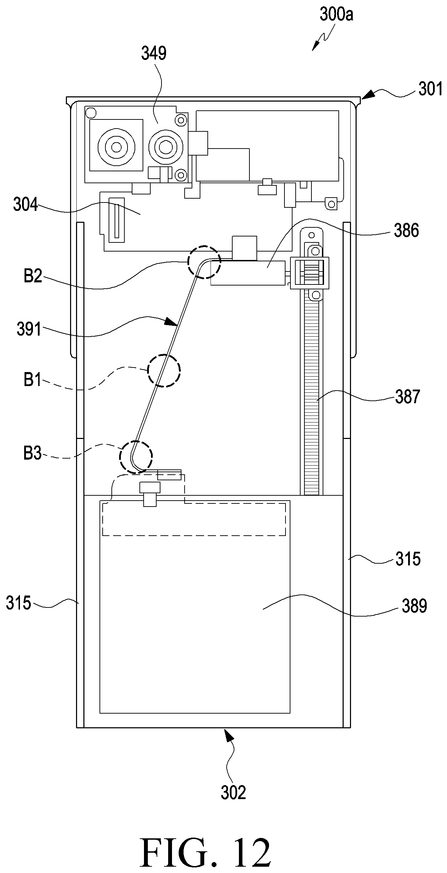

FIG. 10 is a perspective view illustrating an exposed state of a second display area in the electronic device of FIG. 5. FIG. 11 is a perspective view illustrating the exposed state of the second display area in the electronic device of FIG. 5 as viewed in a different direction. FIG. 12 is a plan view or rear view illustrating an exposed state of a second display area in the electronic device of FIG. 5.

Referring further to FIGS. 10 to 12, in a state in which the first housing 301 protrudes to the upper end of the book cover 305, the second display area A2 may be positioned substantially outside the electronic device 300a or on the front surface of the second housing 302. For example, as the first housing 301 gradually protrudes to the upper end of the book cover 305, the second display area A2 (and/or the multi-bar structure 314 of FIG. 6) may gradually move to the front surface of the second housing 302 through the curved section of the guide rail 315. In a state in which the second display area A2 is substantially exposed to the outer space, the flexible printed circuit board 391 may have a substantially straight shape. In an embodiment, even if the flexible printed circuit board 391 has a substantially straight shape, bent portions (e.g., the second bent portion B2 and/or the third bent portion B3) may be partially formed at two opposite ends connected to the first circuit board 304 or the second circuit board 390. In an embodiment, in a state in which the second display area A2 is substantially exposed to the outer space, the flexible printed circuit board 391 may be disposed to be inclined with respect to the sliding direction of the first housing 301. Such a shape or arrangement of the flexible printed circuit board 391 may vary depending on the point at which the flexible printed circuit board 391 is connected to the first circuit board 304 or the second circuit board 390.

According to various embodiments, in a structure in which arrangement of various connectors is restricted, e.g., in a structure in which charging power or wired connection with an external device is restricted, the electronic device 300a may transmit or receive power in a wireless manner such as electromagnetic induction or resonance, and the charging power of the battery 389 may be provided based on the received power. The battery 389 may supply system power for the first circuit board 304 or driving power for the driving motor 386 through the flexible printed circuit board 391. The driving power for the driving motor 386 may require power of a level similar to that of the system power for the first circuit board 304 or a relatively large amount of power, and thus it may be difficult to secure stability of the system power when the driving motor 386 operates. In an embodiment, the elastic force or restoring force of the flexible printed circuit board 391 may substantially hinder the operation of the driving motor 386 or the sliding movement of the first housing 301. For example, when sufficient flexibility is secured in the flexible printed circuit board 391, the operation of the driving motor 386 or the sliding movement of the first housing 301 may be smoother. When the thicknesses or line widths of the conducting line(s) are reduced in the flexible printed circuit board 391, flexibility may be enhanced, but in this case, it may be difficult to stably supply system power or driving power.

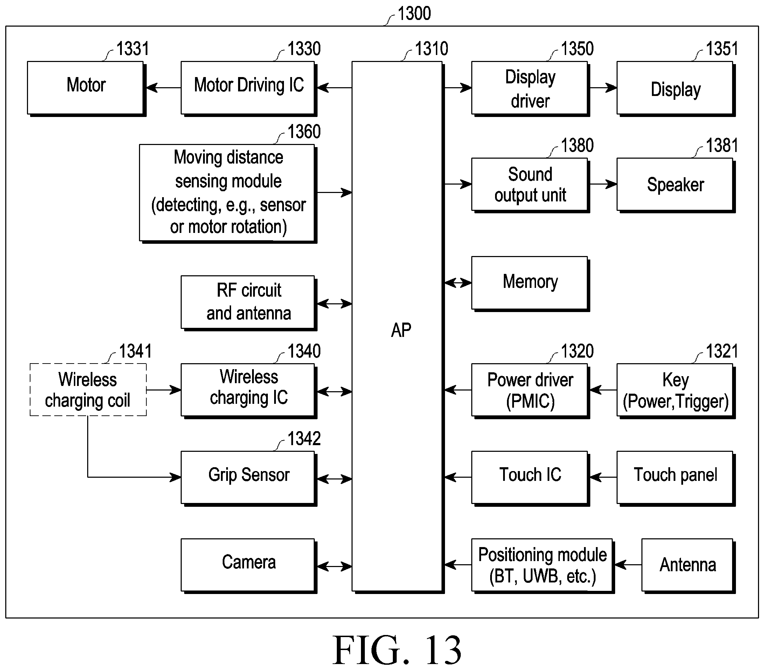

According to various embodiments of the disclosure, considering the limitation of the flexible printed circuit board 391 connecting between the first circuit board 304 and the second circuit board 390 in a portless-type rollable terminal supporting only a wireless charging function, the wireless charging unit and the switching element may be efficiently disposed and connected, thereby stabilizing system power or driving power. This is described with reference to FIGS. 13 to 22.

FIG. 13 is a block diagram illustrating a hardware configuration of an electronic device 1300 according to various embodiments of the disclosure.

Referring further to FIG. 13, the electronic device 1300 according to various embodiments may be of a rollable or slidable form factor type, and may have an extended area of the display 1351. Accordingly, the electronic device 1300 according to various embodiments may include a movement distance sensing module 1360 for sensing the movement distance of the display 1351.

The electronic device 1300 according to various embodiments may control the operation of other components through at least one processor (e.g., the application processor (AP) 1310). Further, the electronic device 1300 may include a power supply circuit 1320 for supplying power to the AP 1310 and other components. In an embodiment, the AP 1310 may be operatively connected to the power supply circuit 1320, the driving circuit 1330, the motor driver 1331, the wireless charger 1340, the first circuit board (not illustrated), the second circuit board (not illustrated), a switching element (not illustrated), and/or a battery (not illustrated).

Further, the electronic device 1300 according to various embodiments may include a driving circuit 1330 (e.g., a motor driving IC) that detects the driving amount of the motor driver 1331 (e.g., a driving motor) or controls the driving speed. In particular, the motor driver 1331 that generates power for movement between the first housing 301 and the second housing 302 may be a high power consuming device that consumes a similar level of power or relatively large power compared to the sum of power consumed by the AP 1310 and other components of the electronic device 1300.

Further, the electronic device 1300 according to various embodiments may include a wireless charging coil 1341 for wireless charging and a wireless charging unit 1340 for converting the signal applied through the wireless charging coil 1341 into power and performing communication for wireless charging. The wireless charging unit 1340 may receive power from the outside through the wireless charging coil 1341, and may provide the received power to the power supply circuit 1320, the driving circuit 1330, and/or the battery (not shown) through a power switching block (e.g., a switching element (not shown)). A grip sensor 1342 for determining whether the electronic device 1300 is gripped in a charging state through the wireless charging coil 1341 may be further provided.

Further, the electronic device 1300 according to various embodiments may further include an operation key 1321 including a power key for controlling power on/off of the electronic device 1300 and/or a trigger key as an input means for changing the size of the display 1351, a display motor driver 1331 and/or a voice output unit 1380 for controlling display (e.g., a visual effect) of a screen on the display 1351 and sound output through the speaker 1381, respectively.

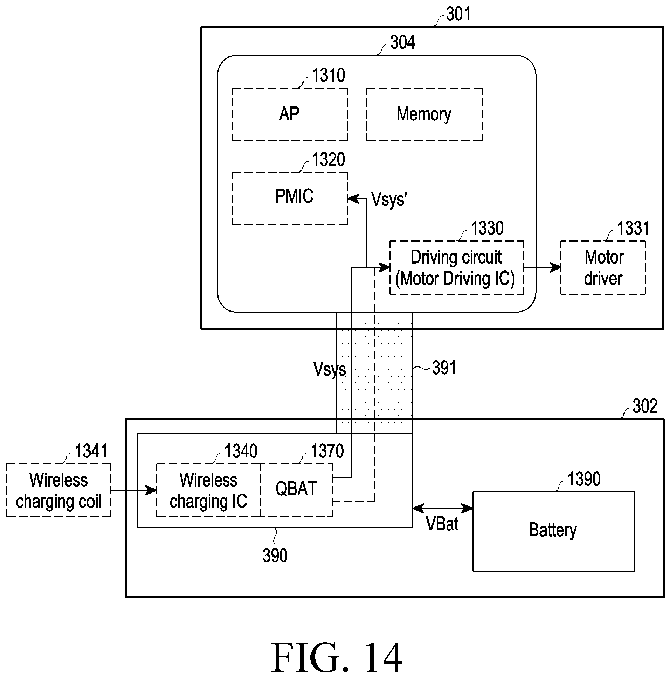

FIG. 14 is a block diagram illustrating a power supply state of an electronic device 1300 according to a first embodiment of the disclosure.

Referring further to FIG. 14, the switching element 1370 and the wireless charging unit 1340 may be disposed on the second circuit board 390 provided in the second housing 302. Specifically, the first circuit board 304 may be fixed to the first housing 301, the second circuit board 390 may be fixed to the second housing 302, and the first circuit board 304 and the second circuit board 390 may be electrically connected through the flexible printed circuit board 391. A power supply circuit 1320 for managing power of the electronic device may be provided on the first circuit board 304, and a battery 1390 fixed to the second housing 302 may be electrically connected to the second circuit board 390.

In this embodiment, the motor driver 1331 and the driving circuit 1330 may be provided on the first circuit board 304, and the wireless charging unit 1340 and the switching element 1370 may be provided on the second circuit board 390.

The wireless charging unit 1340 may receive power through the wireless charging coil 1341, and may provide the power received through the switching element 1370 to the first circuit board 304 provided in the first housing 301. In this case, system power provided to the power supply circuit 1320 and/or the driving circuit 1330 may be supplied to the first circuit board 304 through a power line Vsys designed on the flexible printed circuit board 391.

The switching element 1370 may connect the battery 1390 to the first circuit board 304 to enable the power of the battery 1390 to be used as system power when the difference between the voltage of the first circuit board 304 and the output voltage of the battery 1390 falls below a preset threshold as the amount of system power (power consumed by the power supply circuit 1320 and/or the driving circuit 1330) used in the first circuit board 304 increases.

The switching element 1370 may perform a switching operation between a first state in which the battery 1390 is electrically connected to the power supply circuit 1320 or the driving circuit 1330 and a second state in which an electrical connection between the battery 1390 and the power supply circuit 1320 or the driving circuit 1330 is cut off. When the difference between the voltage Vsys applied to the first circuit board 304 through the switching element 1370 and the output voltage VBat of the battery 1390 is less than or equal to a preset threshold, the switching element 1370 according to an embodiment may operate in the first state in which the battery 1390 is electrically connected to the power supply circuit 1320 or the driving circuit 1330.

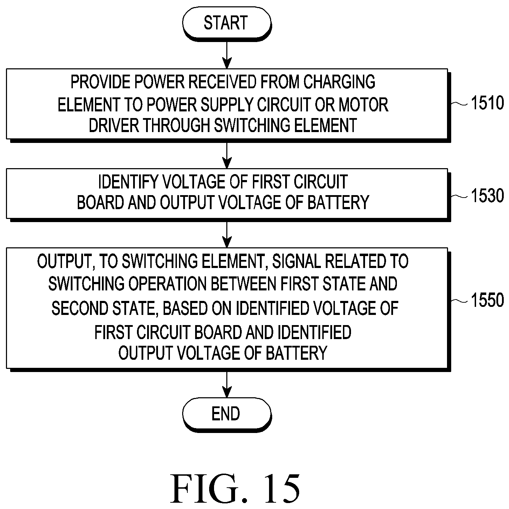

FIG. 15 is a flowchart illustrating a method for operating an electronic device according to an embodiment of the disclosure.

Referring further to FIG. 15, in operation 1510, the electronic device (e.g., at least one processor) may provide power received from the wireless charging unit 1340 to the power supply circuit 1320 or the driving circuit 1330 through the switching element 1370 electrically connected to the wireless charging unit 1340 receiving power from the outside.

In an embodiment, as at least part of operation 1510, the electronic device (e.g., at least one processor) may provide power supplied from the wireless charging unit 1340 or the battery 1390 to the power supply circuit 1320 or the driving circuit 1330 through the flexible printed circuit board 391.

Further, in operation 1530, the electronic device (e.g., at least one processor) may identify the voltage of the first circuit board 304 fixed to the first housing 301 and having the power supply circuit 1320 and the driving circuit 1330, and the output voltage of the battery 1390 fixed to the second housing 302 and electrically connected to the second circuit board 390 electrically connected to the first circuit board 304 through the flexible printed circuit board 391.

Further, in operation 1550, the electronic device (e.g., at least one processor) may output, to the switching element 1370, a signal related to a switching operation between the first state in which the battery 1390 is electrically connected to the power supply circuit 1320 or the driving circuit 1330 and the second state in which the electrical connection between the battery 1390 and the power supply circuit 1320 or the driving circuit 1330 is cut off, based on the voltage of the first circuit board 304 and the output voltage of the battery 1390.

In an embodiment, when the difference between the voltage of the first circuit board 304 and the output voltage of the battery 1390 is less than or equal to a preset threshold, the electronic device (e.g., at least one processor) may output a signal for switching to the first state to the switching element 1370 in operation 1550.

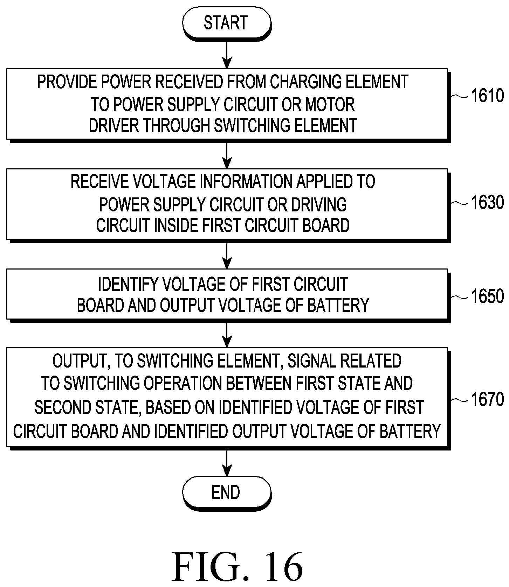

FIG. 16 is a flowchart illustrating a method for operating an electronic device according to another embodiment of the disclosure.

Referring further to FIG. 16, in operation 1610, the electronic device (e.g., at least one processor) may provide power received from the wireless charging unit 1340 to the power supply circuit 1320 or the driving circuit 1330 through the switching element 1370 electrically connected to the wireless charging unit 1340 receiving power from the outside.

In operation 1630, the electronic device (e.g., at least one processor) may receive, from the first circuit board 304, voltage information applied to the power supply circuit 1320 or the driving circuit 1330 inside the first circuit board 304.

Further, in operation 1650, the electronic device (e.g., at least one processor) may identify the voltage of the first circuit board 304 fixed to the first housing 301 and having the power supply circuit 1320 and the driving circuit 1330, and the output voltage of the battery 1390 fixed to the second housing 302 and electrically connected to the second circuit board 390 electrically connected to the first circuit board 304 through the flexible printed circuit board 391. In an embodiment, the operation of identifying the voltage of the first circuit board 304 and the output voltage of the battery 1390 may identify the voltage of the first circuit board 304 based on the voltage information received in operation 1630.

Further, in operation 1670, the electronic device (e.g., at least one processor) may output, to the switching element 1370, a signal related to a switching operation between the first state in which the battery 1390 is electrically connected to the power supply circuit 1320 or the driving circuit 1330 and the second state in which the electrical connection between the battery 1390 and the power supply circuit 1320 or the driving circuit 1330 is cut off, based on the voltage of the first circuit board 304 and the output voltage of the battery 1390.

Specifically, the power transferred to the first circuit board 304 through the flexible printed circuit board 391 may include driving power provided to the motor driver 1331, and thus relatively high power may be transferred through the flexible printed circuit board 391. Accordingly, the voltage Vsys' actually applied to the power supply circuit 1320 or the driving circuit 1330 inside the main board may be lower than the voltage Vsys sensed at the end of the switching element 1370 (e.g., 0.15 V or more). Thus, the voltage Vsys sensed at the end of the switching element 1370 is different from the voltage Vsys' actually applied to the power supply circuit 1320 or the driving circuit 1330 inside the main board, and thus the operation timing (on timing) of the switching element 1370 selectively connecting the battery 1390 to the power supply circuit 1320 or the driving circuit 1330 becomes slow or unstable, so that the electronic device may be powered off, and accordingly, a sudden momentary power loss (SMPL) or the like may occur.

In order to prevent such a problem, in the operation method of the electronic device according to another embodiment of the disclosure, in operation 1630, voltage information applied to the power supply circuit 1320 or the driving circuit 1330 inside the first circuit board 304 may be received from the first circuit board 304 and, in operation 1650, the voltage of the first circuit board 304 may be identified based on the received voltage information.

Specifically, the electronic device (e.g., at least one processor) may receive feedback (reference feedback) of the voltage Vsys' applied to the power supply circuit 1320 or the driving circuit 1330 inside the first circuit board 304 in operation 1630 and, in operation 1670, may output a signal related to the switching operation to the switching element 1370 based on the fed-back voltage Vsys'. In other words, the problem may be resolved by using the voltage of the first circuit board 304 as the voltage of the power supply circuit 1320 or the driving circuit 1330 where load is actually applied in controlling the switching operation of the switching element 1370.

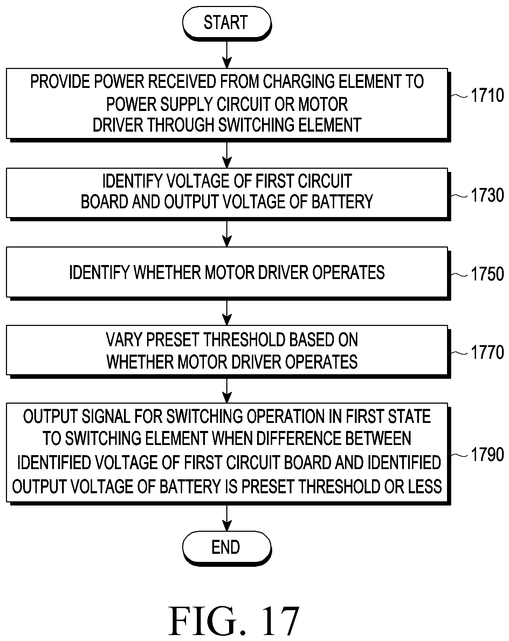

FIG. 17 is a flowchart illustrating a method for operating an electronic device according to another embodiment of the disclosure.

Referring further to FIG. 17, in operation 1710, the electronic device (e.g., at least one processor) may provide power received from the wireless charging unit 1340 to the power supply circuit 1320 or the driving circuit 1330 through the switching element 1370 electrically connected to the wireless charging unit 1340 receiving power from the outside.

Further, in operation 1730, the electronic device (e.g., at least one processor) may identify the voltage of the first circuit board 304 fixed to the first housing 301 and having the power supply circuit 1320 and the driving circuit 1330, and the output voltage of the battery 1390 fixed to the second housing 302 and electrically connected to the second circuit board 390 electrically connected to the first circuit board 304 through the flexible printed circuit board 391.

Further, the electronic device (e.g., at least one processor) may identify whether the motor driver 1331 operates in operation 1750 and, in operation 1770, may vary a preset threshold based on whether the motor driver 1331 operates. For example, the electronic device may set a preset threshold for the operation condition (the voltage difference between Vsys and Vbat) of the switching element 1370 to be higher, to preemptively operate in a state in which the voltage drop at the far end (the power supply circuit 1320 or the driving circuit 1330) of the switching element 1370 is relatively small.

In an embodiment, the electronic device may vary the preset threshold for the operation condition (the voltage difference between Vsys and Vbat) of the switching element 1370 based on whether the motor driver 1331 operates or the current consumption of the driving circuit 1330. For example, the electronic device may vary the preset threshold separately for a case in which the motor driver 1331 operates and a case in which the motor driver 1331 does not operate through current sensing of the switching element 1370 or separately for whether the motor driver 1331 operates based on current consumption of the driving circuit 1330. For example, when the motor driver 1331 operates, the preset threshold may be increased than the existing value. In this case, the offset for increasing the preset threshold may be set to the difference between the voltages of the first circuit board 304 sensed by the switching element 1370 when the operating current of the motor driver 1331 is included and when the operating current of the motor driver 1331 is excluded.

Further, when the difference between the voltage of the first circuit board 304 and the output voltage of the battery 1390 is less than or equal to a preset threshold, the electronic device (e.g., at least one processor) may output a signal for performing a switching operation in the first state to the switching element 1370 in operation 1790. The first state may be a state in which the switching element 1370 electrically connects the battery 1390 to the power supply circuit 1320 or the driving circuit 1330. Conversely, when the difference between the voltage of the first circuit board 304 and the output voltage of the battery 1390 exceeds the preset threshold, the electronic device may output a signal for performing a switching operation in the second state to the switching element 1370.

As an additional embodiment, the electronic device (e.g., at least one processor) may determine a switching operation for connecting the battery 1390 and the first circuit board 304 through the switching element 1370 depending on whether the motor driver 1331 operates. For example, when the driving power of the motor driver 1331 is included, a higher current is supplied to the first circuit board 304 through the switching element 1370, and thus the battery 1390 may be connected to the first circuit board 304 to provide power to the battery 1390. Conversely, when there is no power consumption of the motor driver 1331, a relatively low current is supplied to the first circuit board 304, and thus the connection between the battery 1390 and the first circuit board 304 through the switching element 1370 may be cut off.

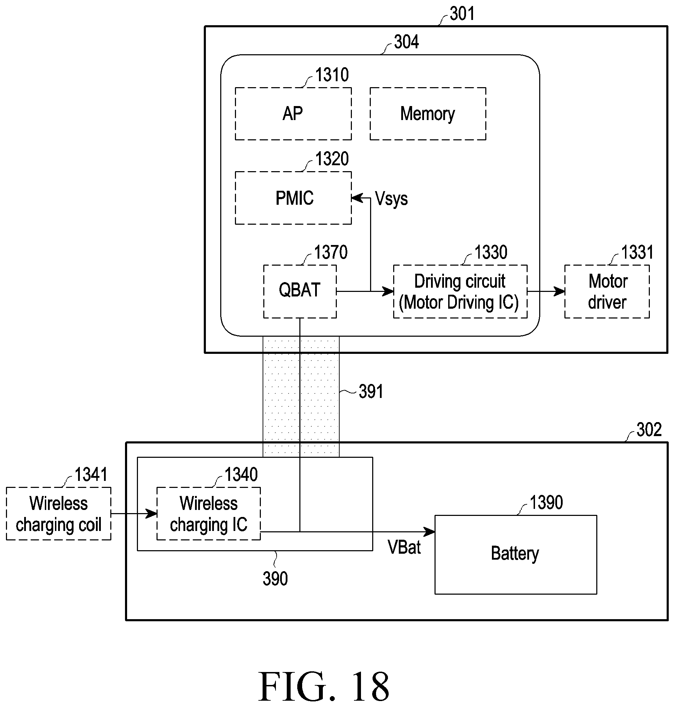

FIG. 18 is a block diagram illustrating a power supply state of an electronic device 1300 according to a second embodiment of the disclosure.

Referring further to FIG. 18, the switching element 1370 may be mounted on the first circuit board 304, and the wireless charging unit 1340 may be mounted on the second circuit board 390. Further, the driving circuit may be provided on the first circuit board 304.

Specifically, the power received by the wireless charging unit 1340 and the power of the battery 1390 may be designed to be provided to the first circuit board 304 through the flexible printed circuit board 391. In this case, since the switching element 1370 is provided on the first circuit board 304, an error between the system voltage (the voltage of the first circuit board 304) sensed at the end of the switching element 1370 and the voltage of the power supply circuit 1320 or the driving circuit 1330 inside the first circuit board 304 may be relatively small. Accordingly, it is possible to prevent sudden power off of the terminal in the low voltage section of the system power.

In other words, in the [first embodiment] in which the wireless charging unit 1340 and the switching element 1370 are mounted together on the second circuit board 390, a difference (e.g., 0.15V or more) between the voltage value of the Far end (the position passing through the flexible printed circuit board 391) with respect to the system voltage Vsys of the switching element 1370 and the voltage value at a position adjacent to the switching element 1370 occurs, thereby causing a change in feedback of the voltage value or the operation condition of the switching element 1370. However, in contrast to this, in the [second embodiment] in which the driving circuit 1330 and the switching element 1370 are provided on the first circuit board 304, and the wireless charging unit 1340 is provided on the second circuit board 390, the error in sensing of the system voltage Vsys of the switching element 1370 may be relatively small. Accordingly, even if the change in the feedback of the system voltage Vsys or in the operation condition of the switching element 1370 is not applied, the switching element 1370 may normally perform the switching operation.

The electronic device according to the [second embodiment] of FIG. 18 may operate according to the operation method of FIG. 15. In an embodiment, as at least part of operation 1530 of identifying the voltage of the first circuit board 304 and the output voltage of the battery 1390 of FIG. 15, the voltage applied from the switching element 1370 to the power supply circuit 1320 or the driving circuit 1330 inside the first circuit board 304 may be identified as the voltage of the first circuit board 304.

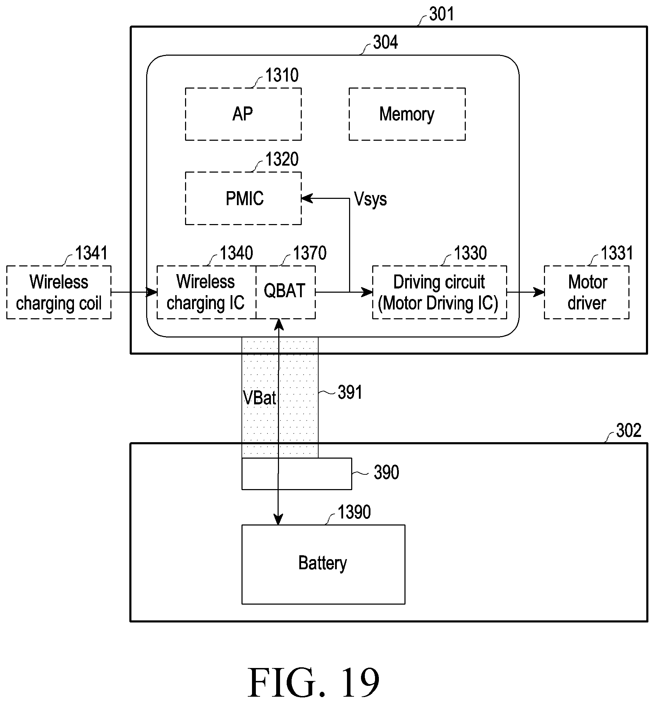

FIG. 19 is a block diagram illustrating a power supply state of an electronic device 1300 according to a third embodiment of the disclosure.

Referring further to FIG. 19, in the electronic device 1300 according to the third embodiment, both the wireless charging unit 1340 and the switching element 1370 may be mounted on the first circuit board 304. Further, the driving circuit 1330 may be provided on the first circuit board 304 having the switching element 1370 and the wireless charging unit 1340. In other words, the driving circuit 1330, the switching element 1370, and the wireless charging unit 1340 may be provided on the first circuit board 304, and external power received from the wireless charging unit 1340 may be provided to the power supply circuit 1320 and/or the driving circuit 1330 through the switching element 1370. Further, according to the switching operation of the switching element 1370, power of the battery 1390 may be selectively provided to the power supply circuit 1320 and/or the driving circuit 1330 through the flexible printed circuit board 391.

According to this configuration, only the power line provided from the battery 1390 to the first circuit board 304 may be wired to the flexible printed circuit board 391, thereby increasing the degree of freedom of designing the power line of the flexible printed circuit board 391. Further, it is possible to reduce a differential current relay (DCR) operation through the flexible printed circuit board 391, thereby preventing a voltage drop of power provided from the battery 1390 through the flexible printed circuit board 391.

FIG. 20 is a plan view or rear view illustrating an exposed state of a second display area in an electronic device according to another embodiment of the disclosure.

Referring to FIG. 20, an electronic device 300b (e.g., the electronic device 101 of FIGS. 1 to 4) is different from the preceding embodiment in the arrangement of the driving motor 386. For example, the driving motor 386 may be disposed in the second housing 302. When the driving motor 386 is disposed in the second housing 302, the rack gear 387 may be disposed in the first housing 301. For example, if the driving motor 386 operates in the second housing 302, the rack gear 387 and/or the first housing 301 may slide relative to the second housing 302. Here, the driving circuit 1330 for controlling power supplied to the motor driver 1331 (e.g., the driving motor 386) may be provided on the second circuit board 390 (e.g., the second circuit board).

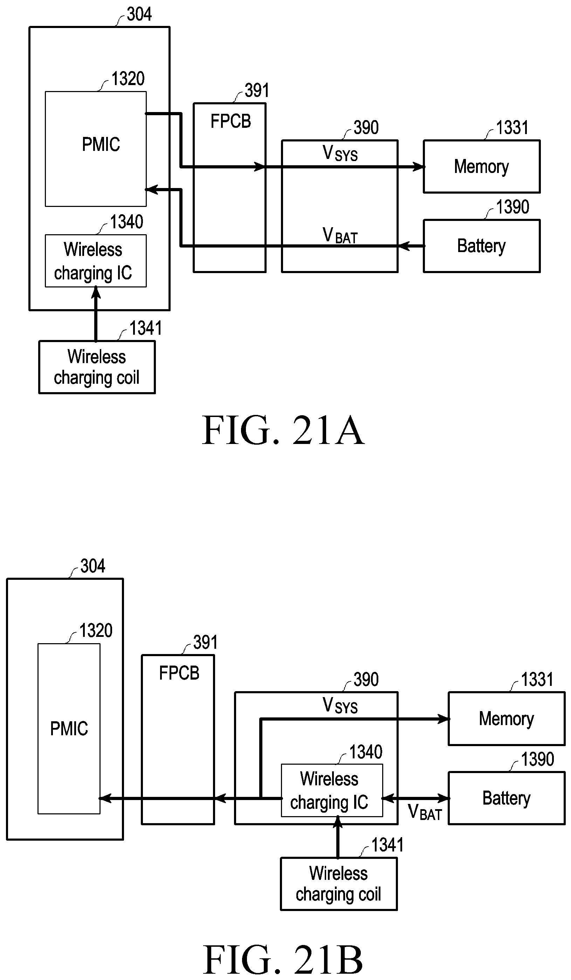

FIG. 21A is a block diagram illustrating an electronic device having a wireless charging unit 1340 on a first circuit board 304 according to an embodiment of the disclosure, and FIG. 21B is a block diagram illustrating an electronic device having a wireless charging unit 1340 on a second circuit board 390 according to an embodiment of the disclosure.

As illustrated in FIG. 21A, in an embodiment in which the motor driver 1331 is positioned in the second frame and the driving circuit 1330 is provided in the second circuit board 390, when the wireless charging unit 1340 and the switching element 1370 are provided on the first circuit board 304, two high power lines Vbat and Vsys should be designed between the first circuit board 304 and the second circuit board 390. In other words, since the power line through the flexible printed circuit board 391 should pass in both directions, a relatively large voltage drop may occur in the flexible printed circuit board 391. Accordingly, the electronic device may be powered off by a differential current relay (DCR) operation through the flexible printed circuit board 391.

To solve this problem, as illustrated in FIG. 21B, in an embodiment in which the motor driver 1331 is positioned in the second frame and the driving circuit 1330 is provided on the second circuit board 390, the wireless charging unit 1340 and the switching element 1370 may be provided on the second circuit board 390, together with the driving circuit 1330. Accordingly, the power line through the flexible printed circuit board 391 between the first circuit board 304 and the second circuit board 390 may be provided only in one direction to provide power to the power supply circuit 1320.

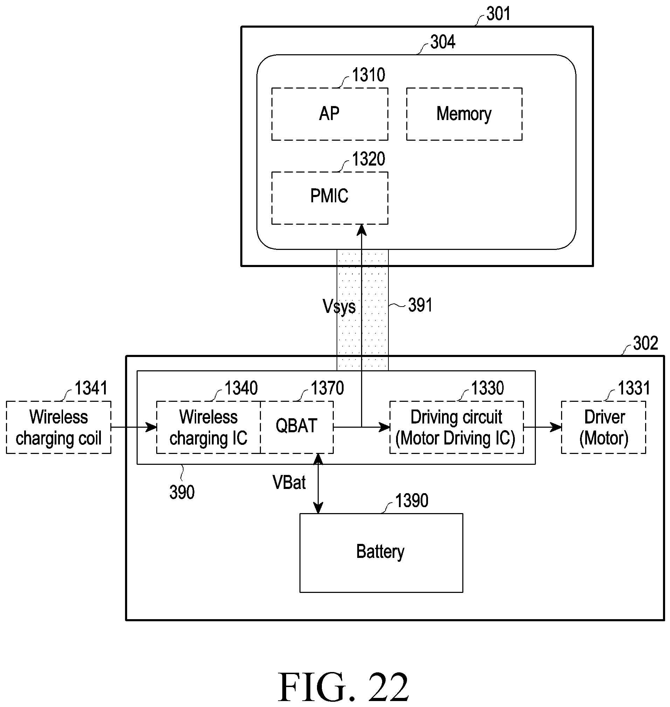

FIG. 22 is a block diagram illustrating a power supply state of an electronic device 1300 according to a fourth embodiment of the disclosure.

Referring further to FIG. 22, the wireless charging unit 1340 and the switching element 1370 may be mounted on the second circuit board 390. In this case, the motor driver 1331, which is a high power-consuming component, may be fixed to the second frame and electrically connected to the second circuit board 390, and the driving circuit 1330 may be provided on the second circuit board 390. In other words, both the switching element 1370 and the wireless charging unit 1340 may be provided on the second circuit board 390 having the driving circuit 1330.

The power received by the wireless charging unit 1340 may be provided to the power supply circuit 1320 and/or the driving circuit 1330 through the switching element 1370, and only the power provided to the power supply circuit 1320 may be transferred to the first circuit board 304 through the flexible printed circuit board 391.

When system power (power consumption of the power supply circuit 1320 and/or the driving circuit 1330) increases, the motor driver 1331 should be connected to the battery 1390 so that the power of the battery 1390 is directly provided to the motor driver 1331, to prevent a voltage drop of the power supply circuit 1320 of the first circuit board 304. To that end, both the wireless charging unit 1340 and the switching element 1370 may be provided on the second circuit board 390 and may be connected to the battery 1390 by the shortest distance. Accordingly, it is possible to prevent the power off of the electronic device due to the occurrence of a high voltage drop in the power supply circuit 1320.

## Claims

1. An electronic device (200, 300a, 300b, 1300), comprising:
a first housing (201, 301);
a second housing (202, 302) disposed to be slidable with respect to the first housing (201);
a flexible display (203, 303, 1351) configured to be reduced or extended based on a slide-in movement or a slide-out movement of the second housing (202, 302);
a motor driver (286, 386, 1331) configured to generate driving force to slide-in or slide-out the second housing (202, 302);
a battery (289, 389, 1390) configured to supply power to the electronic device (200, 300, 300b, 1300);
a first circuit board (248, 304) disposed in the first housing and including a power supply circuit (1320) configured to provide power to at least one component of the electronic device (200, 300a, 300b, 1300);
a second circuit board (249, 390) disposed in the second housing and electrically connected to the battery (289, 389, 1390);
a flexible printed circuit board (391) electrically connecting the first circuit board (248, 304) and the second circuit board (249, 390);
a wireless charging unit (1340) configured to receive power from outside of the electronic device (200, 300a, 300b);
a switching element (1370) configured to switch, while receiving the power from outside of the electronic device (200, 300a, 300b) through the wireless charging unit (1340), between a first state in which the battery (289, 389, 1390) is electrically connected to the power supply circuit (1320) or the motor driver (286, 386, 1331) and a second state in which the battery (289, 389, 1390) is electrically disconnected to the power supply circuit (1320) and the motor driver (286, 386, 1331), and
at least one processor (120) operatively connected to the motor driver (286, 386, 1331), the first circuit board (248, 304), the second circuit board (249, 390), and the switching element (1370), wherein the at least one processor (120) is configured to: identify a voltage (Vsys) of the first circuit board (248, 304) and an output voltage (Vbat) of the battery (289, 389, 1390), while the motor driver (286, 386, 1331) is operated, and
based on a difference between the voltage of the first circuit board (248, 304) and the output voltage of the battery, output, to the switching element (1370), a signal related to a switching operation between the first state and the second state.

2. The electronic device of claim 1, wherein a driving circuit (1330) configured to supply power to the motor driver (286, 386, 1331) and be provided on the first circuit board (248, 304),
wherein the wireless charging unit (1340) and the switching element (1370) are provided on the second circuit board (249, 390), and
wherein the switching element (1370) is configured to provide power received from the wireless charging unit (1340) or the battery (289, 389, 1390) to the power supply circuit (1320) or the driving circuit (1330) through the flexible printed circuit board (391).

3. The electronic device of claim 2,
wherein the voltage (Vsys) of the first circuit board (248, 304) includes a voltage applied to the first circuit board (248, 304) through the switching element (1370) and the flexible printed circuit board (391), and
wherein the at least one processor (120) is configured to, as at least portion of the operation of outputting, to the switching element (1370) a signal related to the switching operation, when the switching element (1370) is in the first state, output a signal for the switching operation to the switching element (1370) when a difference between the voltage applied to the first printed circuit board (248, 304) through the switching element (1370) and the output voltage of the battery (VBat) is less than or equal to a preset threshold.

4. The electronic device of claim 3, wherein the preset threshold is preset to be varied based on whether the motor driver (286, 386, 1331) operates.

5. The electronic device of claim 2, wherein the at least one processor (120) is configured to as at least part of the operation of outputting the signal related to the switching operation to the switching element (1370), output the signal related to the switching operation to the switching element (1370), based on a voltage applied to the power supply circuit (1320) or the driving circuit (1330) inside the first circuit board (248, 304).

6. The electronic device of claim 2, wherein the at least one processor (120) is configured to as at least part of the operation of outputting, to the switching element (1370) a signal related to the switching operation; output a signal for the switching operation in the first state when the motor driver (286, 386, 1331) operates, and output a signal for the switching operation in the second state when the motor driver (286, 386, 1331) does not operate.

7. The electronic device of claim 1, wherein a driving circuit (1330) configured to supply power to the motor driver (286, 386, 1331), and the switching element (1370) are provided on the first circuit board (248, 304),
wherein the wireless charging unit (1340) is provided on the second circuit board (249, 390), and
wherein the switching element (1370) is configured to provide the power received from the wireless charging unit (1340) or the battery (289, 389, 1390) to the power supply circuit (1320) or the driving circuit (1330) through the flexible printed circuit board (391).

8. The electronic device of claim 7, wherein the at least one processor (120) is configured to as at least part of the operation of outputting, to the switching element (1370) a signal related to the switching operation, output a signal for the switching operation in the first state when a difference between a voltage applied to the power supply circuit (1320) or the driving circuit (1330) through the switching element (1370) and an output voltage of the battery (VBat) is less than or equal to a preset threshold.

9. The electronic device of claim 1, wherein both the switching element (1370) and the wireless charging unit (1340) are provided on one side having a driving circuit (1330) supplying power to the motor driver (286, 386, 1331) with respect to the flexible printed circuit board (391).

10. The electronic device of claim 9, wherein the driving circuit (1330) configured to supply power to the motor driver (286, 386, 1331) and be provided on the first circuit board (248, 304), wherein both the switching element (1370) and the wireless charging unit (1340) are provided on the first circuit board (248, 304) having the driving circuit (1330), and wherein the switching element (1370) is electrically connected to the second circuit board (249, 390) through the flexible printed circuit board (391).

11. The electronic device of claim 10, wherein the flexible printed circuit board (391) is configured to transfer the power received from the battery (289, 389, 1390) to the power supply circuit (1320) or the driving circuit (1330) through the switching element (1370) when the switching element (1370) is in the first state.

12. The electronic device of claim 9, wherein the driving circuit (1330) is configured to supply power to the motor driver (286, 386, 1331) and be provided on the second circuit board (249, 390), wherein both the switching element (1370) and the wireless charging unit (1340) are provided on the second circuit board (249, 390) having the driving circuit (1330), and wherein the switching element (1370) is electrically connected to the first circuit board (248, 304) through the flexible printed circuit board (391).

13. The electronic device of claim 12, wherein the flexible printed circuit board (391) is configured to transfer the power received from the wireless charging unit (1340) or the battery (289, 389, 1390) to the power supply circuit (1320) through the switching element (1370).

14. A method for operating an electronic device, the method comprising:
identifying a voltage of a first circuit board (248, 304) of the electronic device and an output voltage of a battery (289, 389, 1390) of the electronic device, while a motor driver (286, 386, 1331) is operated, and
based on a difference between a voltage applied to the flexible printed circuit board (391) through a switching element (1370) of the electronic device and the output voltage of the battery (VBat), outputting, to the switching element (1370), a signal related to a switching operation between a first state and a second state,
wherein the first state is indicating that the battery (289, 389, 1390) is electrically connected to the power supply circuit (1320) or the motor driver (286, 386, 1331) and the second state is indicating that the battery (289, 389, 1390) is electrically disconnected to the power supply circuit (1320) and the motor driver (286, 386, 1331), while receiving a power from outside of the electronic device (200, 300a, 300b) through a wireless charging unit (1340) of the electronic device (200, 300a, 300b).

15. The method of claim 14,
wherein a driving circuit is configured to supply power to the motor driver and be provided on the first circuit board, wherein the wireless charging unit and the switching element are provided on the second circuit board, and wherein providing the power to the power supply circuit or the driving circuit through the switching element provides the power received from the wireless charging unit or the battery to the power supply circuit or the driving circuit through the flexible printed circuit board.

## Patentansprüche

1. Elektronische Vorrichtung (200, 300a, 300b, 1300), umfassend:
ein erstes Gehäuse (201,301);
ein zweites Gehäuse (202, 302), das so angeordnet ist, dass es in Bezug auf das erste Gehäuse (201) verschiebbar ist;
eine flexible Anzeige (203, 303, 1351), die dazu konfiguriert ist, basierend auf einer Einschubbewegung oder einer Ausschubbewegung des zweiten Gehäuses (202, 302) reduziert oder ausgefahren zu werden;
einen Motortreiber (286, 386, 1331), der dazu konfiguriert ist, Antriebskraft zum Einschieben oder Ausschieben des zweiten Gehäuses (202, 302) zu erzeugen;
eine Batterie (289, 389, 1390), die dazu konfiguriert ist, die elektronische Vorrichtung (200, 300, 300b, 1300) mit Strom zu versorgen;
eine erste Platine (248, 304), die in dem ersten Gehäuse angeordnet ist und eine Stromversorgungsschaltung (1320) beinhaltet, die dazu konfiguriert ist, mindestens eine Komponente der elektronischen Vorrichtung (200, 300a, 300b, 1300) mit Strom zu versorgen;
eine zweite Platine (249, 390), die in dem zweiten Gehäuse angeordnet ist und elektrisch mit der Batterie (289, 389, 1390) verbunden ist;
eine flexible Leiterplatte (391), die die erste Platine (248, 304) und die zweite Platine (249, 390) elektrisch verbindet;
eine drahtlose Ladeeinheit (1340), die dazu konfiguriert ist, Strom von außerhalb der elektronischen Vorrichtung (200, 300a, 300b) zu empfangen;
ein Schaltelement (1370), das dazu konfiguriert ist, während es den Strom von außerhalb der elektronischen Vorrichtung (200, 300a, 300b) über die drahtlose Ladeeinheit (1340) empfängt, zwischen einem ersten Zustand, in dem die Batterie (289, 389, 1390) elektrisch mit der Stromversorgungsschaltung (1320) oder dem Motortreiber (286, 386, 1331) verbunden ist, und einem zweiten Zustand, in dem die Batterie (289, 389, 1390) elektrisch von der Stromversorgungsschaltung (1320) und dem Motortreiber (286, 386, 1331) getrennt ist, zu schalten, und
mindestens einen Prozessor (120), der betriebsmäßig mit dem Motortreiber (286, 386, 1331), der ersten Platine (248, 304), der zweiten Platine (249, 390) und dem Schaltelement (1370) verbunden ist, wobei der mindestens eine Prozessor (120) zu Folgendem konfiguriert ist:
Identifizieren einer Spannung (Vsys) der ersten Platine (248, 304) und einer Ausgangsspannung (Vbat) der Batterie (289, 389, 1390), während der Motortreiber (286, 386, 1331) betrieben wird, und
basierend auf einer Differenz zwischen der Spannung der ersten Platine (248, 304) und der Ausgangsspannung der Batterie, Ausgeben, an das Schaltelement (1370), eines Signals, das sich auf einen Schaltvorgang zwischen dem ersten Zustand und dem zweiten Zustand bezieht.

2. Elektronische Vorrichtung nach Anspruch 1, wobei eine Treiberschaltung (1330) dazu konfiguriert ist, den Motortreiber (286, 386, 1331) mit Strom zu versorgen, und auf der ersten Platine (248, 304) bereitgestellt ist, wobei die drahtlose Ladeeinheit (1340) und das Schaltelement (1370) auf der zweiten Platine (249, 390) bereitgestellt sind, und
wobei das Schaltelement (1370) dazu konfiguriert ist, der Stromversorgungsschaltung (1320) oder der Treiberschaltung (1330) über die flexible Leiterplatte (391) Strom bereitzustellen, der von der drahtlosen Ladeeinheit (1340) oder der Batterie (289, 389, 1390) empfangen wird.

3. Elektronische Vorrichtung nach Anspruch 2,
wobei die Spannung (Vsys) der ersten Platine (248, 304) eine Spannung beinhaltet, die über das Schaltelement (1370) und die flexible Leiterplatte (391) an die erste Platine (248, 304) angelegt wird, und
wobei der mindestens eine Prozessor (120) dazu konfiguriert ist, als mindestens einen Abschnitt des Vorgangs des Ausgebens eines Signal, das sich auf den Schaltvorgang bezieht, an das Schaltelement (1370), wenn sich das Schaltelement (1370) in dem ersten Zustand befindet, ein Signal für den Schaltvorgang an das Schaltelement (1370) auszugeben, wenn eine Differenz zwischen der über das Schaltelement (1370) an die erste Leiterplatte (248, 304) angelegten Spannung und der Ausgangsspannung der Batterie (VBat) kleiner oder gleich einem voreingestellten Schwellenwert ist.

4. Elektronische Vorrichtung nach Anspruch 3, wobei der voreingestellte Schwellenwert voreingestellt ist, um basierend darauf variiert zu werden, ob der Motortreiber (286, 386, 1331) arbeitet.

5. Elektronische Vorrichtung nach Anspruch 2, wobei der mindestens eine Prozessor (120) dazu konfiguriert ist, als mindestens einen Teil des Vorgangs des Ausgebens des Signals, das sich auf den Schaltvorgang bezieht, an das Schaltelement (1370), das Signal, das sich auf den Schaltvorgang bezieht, basierend auf einer Spannung, die an die Stromversorgungsschaltung (1320) oder die Treiberschaltung (1330) innerhalb der ersten Platine (248, 304) angelegt wird, an das Schaltelement (1370) auszugeben.

6. Elektronische Vorrichtung nach Anspruch 2, wobei der mindestens eine Prozessor (120) dazu konfiguriert ist, als mindestens einen Teil des Vorgangs des Ausgebens eines Signal, das sich auf den Schaltvorgang bezieht, an das Schaltelement (1370); ein Signal für den Schaltvorgang in dem ersten Zustand auszugeben, wenn der Motortreiber (286, 386, 1331) arbeitet, und ein Signal für den Schaltvorgang in dem zweiten Zustand auszugeben, wenn der Motortreiber (286, 386, 1331) nicht arbeitet.

7. Elektronische Vorrichtung nach Anspruch 1, wobei eine Treiberschaltung (1330) dazu konfiguriert ist, den Motortreiber (286, 386, 1331) mit Strom zu versorgen, und das Schaltelement (1370) auf der ersten Platine (248, 304) bereitgestellt ist,
wobei die drahtlose Ladeeinheit (1340) auf der zweiten Platine (249, 390) bereitgestellt ist, und
wobei das Schaltelement (1370) dazu konfiguriert ist, der Stromversorgungsschaltung (1320) oder der Treiberschaltung (1330) über die flexible Leiterplatte (391) den Strom bereitzustellen, der von der drahtlosen Ladeeinheit (1340) oder der Batterie (289, 389, 1390) empfangen wird.

8. Elektronische Vorrichtung nach Anspruch 7, wobei der mindestens eine Prozessor (120) dazu konfiguriert ist, als mindestens einen Teil des Vorgangs des Ausgebens eines Signals, das sich auf den Schaltvorgang bezieht, an das Schaltelement (1370), ein Signal für den Schaltvorgang in dem ersten Zustand auszugeben, wenn eine Differenz zwischen einer über das Schaltelement (1370) an die Stromversorgungsschaltung (1320) oder die Treiberschaltung (1330) angelegten Spannung und einer Ausgangsspannung der Batterie (VBat) kleiner oder gleich einem voreingestellten Schwellenwert ist.

9. Elektronische Vorrichtung nach Anspruch 1, wobei sowohl das Schaltelement (1370) als auch die drahtlose Ladeeinheit (1340) auf einer Seite bereitgestellt sind, die eine Treiberschaltung (1330) aufweist, die den Motortreiber (286, 386, 1331) in Bezug auf die flexible Leiterplatte (391) mit Strom versorgt.

10. Elektronische Vorrichtung nach Anspruch 9, wobei die Treiberschaltung (1330) dazu konfiguriert ist, den Motortreiber (286, 386, 1331) mit Strom zu versorgen, und auf der ersten Platine (248, 304) bereitgestellt ist, wobei sowohl das Schaltelement (1370) als auch die drahtlose Ladeeinheit (1340) auf der ersten Platine (248, 304) bereitgestellt sind, die die Treiberschaltung (1330) aufweist, und wobei das Schaltelement (1370) über die flexible Leiterplatte (391) elektrisch mit der zweiten Platine (249, 390) verbunden ist.

11. Elektronische Vorrichtung nach Anspruch 10, wobei die flexible Leiterplatte (391) dazu konfiguriert ist, den Strom, der von der Batterie (289, 389, 1390) empfangen wird, über das Schaltelement (1370) an die Stromversorgungsschaltung (1320) oder die Treiberschaltung (1330) zu übertragen, wenn sich das Schaltelement (1370) in dem ersten Zustand befindet.

12. Elektronische Vorrichtung nach Anspruch 9, wobei die Treiberschaltung (1330) dazu konfiguriert ist, den Motortreiber (286, 386, 1331) mit Strom zu versorgen, und auf der zweiten Platine (249, 390) bereitgestellt ist, wobei sowohl das Schaltelement (1370) als auch die drahtlose Ladeeinheit (1340) auf der zweiten Platine (249, 390) bereitgestellt sind, die die Treiberschaltung (1330) aufweist, und wobei das Schaltelement (1370) über die flexible Leiterplatte (391) elektrisch mit der ersten Platine (248, 304) verbunden ist.

13. Elektronische Vorrichtung nach Anspruch 12, wobei die flexible Leiterplatte (391) dazu konfiguriert ist, den Strom, der von der drahtlosen Ladeeinheit (1340) oder der Batterie (289, 389, 1390) empfangen wird, über das Schaltelement (1370) an die Stromversorgungsschaltung (1320) zu übertragen.

14. Verfahren zum Betreiben einer elektronischen Vorrichtung, wobei das Verfahren Folgendes umfasst:
Identifizieren einer Spannung einer ersten Platine (248, 304) der elektronischen Vorrichtung und einer Ausgangsspannung einer Batterie (289, 389, 1390) der elektronischen Vorrichtung, während ein Motortreiber (286, 386, 1331) betrieben wird, und
basierend auf einer Differenz zwischen einer über ein Schaltelement (1370) der elektronischen Vorrichtung an die flexible Leiterplatte (391) angelegten Spannung und der Ausgangsspannung der Batterie (VBat), Ausgeben, an das Schaltelement (1370), eines Signals, das sich auf einen Schaltvorgang zwischen einem ersten Zustand und einem zweiten Zustand bezieht,
wobei der erste Zustand angibt, dass die Batterie (289, 389, 1390) elektrisch mit der Stromversorgungsschaltung (1320) oder dem Motortreiber (286, 386, 1331) verbunden ist, und der zweite Zustand angibt, dass die Batterie (289, 389, 1390) elektrisch von der Stromversorgungsschaltung (1320) und dem Motortreiber (286, 386, 1331) getrennt ist, während sie einen Strom von außerhalb der elektronischen Vorrichtung (200, 300a, 300b) über eine drahtlose Ladeeinheit (1340) der elektronischen Vorrichtung (200, 300a, 300b) empfängt.

15. Verfahren nach Anspruch 14,
wobei eine Treiberschaltung dazu konfiguriert ist, den Motortreiber mit Strom zu versorgen, und auf der ersten Platine bereitgestellt ist, wobei die drahtlose Ladeeinheit und das Schaltelement auf der zweiten Platine bereitgestellt sind und wobei das Bereitstellen des Stroms an die Stromversorgungsschaltung oder die Treiberschaltung über das Schaltelement den Strom, der von der drahtlosen Ladeeinheit oder der Batterie empfangen wird, an die Stromversorgungsschaltung oder die Treiberschaltung über die flexible Leiterplatte bereitstellt.

## Revendications

1. Dispositif électronique (200, 300a, 300b, 1300), comprenant :
un premier boîtier (201, 301) ;
un second boîtier (202, 302) disposé pour pouvoir coulisser par rapport au premier boîtier (201) ;
un dispositif d'affichage flexible (203, 303, 1351) configuré pour être réduit ou étendu sur la base d'un mouvement de coulissement vers l'intérieur ou d'un mouvement de coulissement vers l'extérieur du second boîtier (202, 302) ;
un dispositif d'entraînement de moteur (286, 386, 1331) configuré pour générer une force d'entraînement afin de faire coulisser le second boîtier (202, 302) vers l'intérieur ou vers l'extérieur ;
une batterie (289, 389, 1390) configurée pour alimenter en énergie le dispositif électronique (200, 300, 300b, 1300) ;
une première carte de circuit (248, 304) disposée dans le premier boîtier et comprenant un circuit d'alimentation électrique (1320) configuré pour fournir de l'énergie à au moins un composant du dispositif électronique (200, 300a, 300b, 1300) ;
une seconde carte de circuit (249, 390) disposée dans le second boîtier et connectée électriquement à la batterie (289, 389, 1390) ;
une carte de circuit imprimé flexible (391) connectant électriquement la première carte de circuit (248, 304) et la seconde carte de circuit (249, 390) ;
une unité de charge sans fil (1340) configurée pour recevoir de l'énergie en provenance de l'extérieur du dispositif électronique (200, 300a, 300b) ;
un élément de commutation (1370) configuré pour commuter, tout en recevant de l'énergie en provenance de l'extérieur du dispositif électronique (200, 300a, 300b) par l'intermédiaire de l'unité de charge sans fil (1340), entre un premier état dans lequel la batterie (289, 389, 1390) est électriquement connectée au circuit d'alimentation électrique (1320) ou au dispositif d'entraînement de moteur (286, 386, 1331) et un second état dans lequel la batterie (289, 389, 1390) est électriquement déconnectée du circuit d'alimentation électrique (1320) et du dispositif d'entraînement de moteur (286, 386, 1331), et
au moins un processeur (120) connecté fonctionnellement au dispositif d'entraînement de moteur (286, 386, 1331), à la première carte de circuit (248, 304), à la seconde carte de circuit (249, 390) et à l'élément de commutation (1370), ledit au moins un processeur (120) étant configuré pour : identifier une tension (Vsys) de la première carte de circuit (248, 304) et une tension de sortie (Vbat) de la batterie (289, 389, 1390), pendant que le dispositif d'entraînement de moteur (286, 386, 1331) est actionné, et
sur la base d'une différence entre la tension de la première carte de circuit (248, 304) et la tension de sortie de la batterie, émettre en sortie, vers l'élément de commutation (1370), un signal lié à une opération de commutation entre le premier état et le second état.

2. Dispositif électronique de la revendication 1, un circuit de pilotage (1330) configuré pour fournir de l'énergie au dispositif d'entraînement de moteur (286, 386, 1331) et être prévu sur la première carte de circuit (248, 304),
ladite unité de charge sans fil (1340) et ledit élément de commutation (1370) étant prévus sur la seconde carte de circuit (249, 390), et
ledit élément de commutation (1370) étant configuré pour fournir de l'énergie reçue en provenance de l'unité de charge sans fil (1340) ou de la batterie (289, 389, 1390) au circuit d'alimentation électrique (1320) ou au circuit de pilotage (1330) par l'intermédiaire de la carte de circuit imprimé souple (391).

3. Dispositif électronique de la revendication 2,
ladite tension (Vsys) de la première carte de circuit (248, 304) comprenant une tension appliquée à la première carte de circuit (248, 304) par l'intermédiaire de l'élément de commutation (1370) et de la carte de circuit imprimé flexible (391), et
ledit au moins un processeur (120) étant configuré pour, en tant qu'au moins une partie de l'opération d'émission en sortie vers l'élément de commutation (1370) d'un signal lié à l'opération de commutation lorsque l'élément de commutation (1370) est dans le premier état, émettre en sortie un signal pour l'opération de commutation à l'élément de commutation (1370) lorsqu'une différence entre la tension appliquée à la première carte de circuit imprimé (248, 304) par l'intermédiaire de l'élément de commutation (1370) et la tension de sortie de la batterie (VBat) est inférieure ou égale à un seuil prédéfini.

4. Dispositif électronique de la revendication 3, ledit seuil prédéfini étant prédéfini pour être modifié sur la base de l'actionnement ou non du dispositif d'entraînement de moteur (286, 386, 1331).

5. Dispositif électronique de la revendication 2, ledit au moins un processeur (120) étant configuré pour, en tant qu'au moins une partie de l'opération d'émission en sortie du signal lié à l'opération de commutation vers l'élément de commutation (1370), émettre en sortie le signal lié à l'opération de commutation vers l'élément de commutation (1370), sur la base d'une tension appliquée au circuit d'alimentation électrique (1320) ou au circuit de pilotage (1330) à l'intérieur de la première carte de circuit (248, 304).

6. Dispositif électronique de la revendication 2, ledit au moins un processeur (120) étant configuré pour, en tant qu'au moins une partie de l'opération d'émission en sortie vers l'élément de commutation (1370) d'un signal lié à l'opération de commutation ; émettre en sortie un signal pour l'opération de commutation dans le premier état lorsque le dispositif d'entraînement de moteur (286, 386, 1331) fonctionne, et émettre en sortie un signal pour l'opération de commutation dans le second état lorsque le dispositif d'entraînement de moteur (286, 386, 1331) ne fonctionne pas.

7. Dispositif électronique de la revendication 1, un circuit de pilotage (1330) configuré pour fournir de l'énergie au dispositif d'entraînement de moteur (286, 386, 1331), et ledit élément de commutation (1370) étant prévus sur la première carte de circuit (248, 304), ladite unité de charge sans fil (1340) étant prévue sur la seconde carte de circuit (249, 390), et
ledit élément de commutation (1370) étant configuré pour fournir de l'énergie reçue en provenance de l'unité de charge sans fil (1340) ou de la batterie (289, 389, 1390) au circuit d'alimentation électrique (1320) ou au circuit de pilotage (1330) par l'intermédiaire de la carte de circuit imprimé flexible (391).

8. Dispositif électronique de la revendication 7, ledit au moins un processeur (120) étant configuré pour, en tant qu'au moins une partie de l'opération d'émission en sortie vers l'élément de commutation (1370) d'un signal lié à l'opération de commutation, émettre en sortie un signal pour l'opération de commutation dans le premier état lorsqu'une différence entre une tension appliquée au circuit d'alimentation électrique (1320) ou au circuit de pilotage (1330) par l'intermédiaire de l'élément de commutation (1370) et une tension de sortie de la batterie (VBat) est inférieure ou égale à un seuil prédéfini.

9. Dispositif électronique de la revendication 1, à la fois ledit élément de commutation (1370) et ladite unité de charge sans fil (1340) étant prévus sur un côté possédant un circuit de pilotage (1330) fournissant de l'énergie au dispositif d'entraînement de moteur (286, 386, 1331) par rapport à la carte de circuit imprimé souple (391).

10. Dispositif électronique de la revendication 9, ledit circuit de pilotage (1330) étant configuré pour fournir de l'énergie au dispositif d'entraînement de moteur (286, 386, 1331) et être prévu sur la première carte de circuit (248, 304), à la fois ledit élément de commutation (1370) et ladite unité de charge sans fil (1340) étant prévus sur la première carte de circuit (248, 304) possédant le circuit de pilotage (1330), et ledit élément de commutation (1370) étant électriquement connecté à la seconde carte de circuit (249, 390) par l'intermédiaire de la carte de circuit imprimé flexible (391).

11. Dispositif électronique de la revendication 10, ladite carte de circuit imprimé flexible (391) étant configurée pour transférer de l'énergie reçue en provenance de la batterie (289, 389, 1390) au circuit d'alimentation électrique (1320) ou au circuit de pilotage (1330) par l'intermédiaire de l'élément de commutation (1370) lorsque l'élément de commutation (1370) est dans le premier état.

12. Dispositif électronique de la revendication 9, ledit circuit de pilotage (1330) étant configuré pour fournir de l'énergie au dispositif d'entraînement de moteur (286, 386, 1331) et être prévu sur la seconde carte de circuit (249, 390), à la fois ledit élément de commutation (1370) et ladite unité de charge sans fil (1340) étant prévus sur la seconde carte de circuit (249, 390) possédant le circuit de pilotage (1330), et ledit élément de commutation (1370) étant électriquement connecté à la première carte de circuit (248, 304) par l'intermédiaire de la carte de circuit imprimé flexible (391).

13. Dispositif électronique de la revendication 12, ladite carte de circuit imprimé flexible (391) étant configurée pour transférer l'énergie reçue en provenance de l'unité de charge sans fil (1340) ou de la batterie (289, 389, 1390) au circuit d'alimentation électrique (1320) par l'intermédiaire de l'élément de commutation (1370).

14. Procédé permettant l'exploitation d'un dispositif électronique, le procédé comprenant :
l'identification d'une tension d'une première carte de circuit (248, 304) du dispositif électronique et d'une tension de sortie d'une batterie (289, 389, 1390) du dispositif électronique, pendant qu'un dispositif d'entraînement de moteur (286, 386, 1331) est actionné, et
sur la base d'une différence entre une tension appliquée à la carte de circuit imprimé flexible (391) par l'intermédiaire d'un élément de commutation (1370) du dispositif électronique et la tension de sortie de la batterie (VBat), l'émission en sortie, vers l'élément de commutation (1370), d'un signal lié à une opération de commutation entre un premier état et un second état,
ledit premier état indiquant que la batterie (289, 389, 1390) est électriquement connectée au circuit d'alimentation électrique (1320) ou au dispositif d'entraînement de moteur (286, 386, 1331) et ledit second état indiquant que la batterie (289, 389, 1390) est électriquement déconnectée du circuit d'alimentation électrique (1320) et du dispositif d'entraînement de moteur (286, 386, 1331), tout en recevant de l'énergie en provenance de l'extérieur du dispositif électronique (200, 300a, 300b) par l'intermédiaire d'une unité de charge sans fil (1340) du dispositif électronique (200, 300a, 300b).

15. Procédé de la revendication 14,
ledit circuit de pilotage étant configuré pour fournir de l'énergie au dispositif d'entraînement de moteur et être prévu sur la première carte de circuit, ladite unité de charge sans fil et ledit élément de commutation étant prévus sur la seconde carte de circuit, et ladite fourniture de l'énergie au circuit d'alimentation électrique ou au circuit de pilotage par l'intermédiaire de l'élément de commutation fournissant l'énergie reçue en provenance de l'unité de charge sans fil ou de la batterie au circuit d'alimentation électrique ou au circuit de pilotage par l'intermédiaire de la carte de circuit imprimé flexible.
